# EUROPEAN PATENT SPECIFICATION

(11) **EP 1 754 736 B1**
(45) Date of publication and mention of the grant of the patent: **11.05.2011**
(21) Application number: 06014918.4
(22) Date of filing: 18.07.2006
(51) Int. Cl.: C08G 61/12

(54) **Process for the polymerisation of thiophene or selenophene derivatives**
Verfahren zur Polymerisation von Thiophen- oder Selenophenderivaten
Procédé de polymérisation de dérivés de thiophène ou de sélénophène

(30) Priority: 16.08.2005 EP 05017718; 09.02.2006 EP 06002595
(43) Date of publication of application: 21.02.2007
(73) Proprietor: Merck Patent GmbH, 64293 Darmstadt (DE)
(72) Inventor: Tierney, Steven, Southampton SO 15 7QW (GB); Heeney, Martin, Southampton SO14 6TQ (GB); Zhang, Weimin, Southampton SO16 1QJ (GB); Higgins, Simon, Woolton, Liverpool L25 6DH (GB); Liversedge, Iain, Charlotte, NC 28223-0001 (US)

(56) References cited:
- EP-A- 1 510 535
- WO-A-2005/111045
- WO-A-2006/021277
- WO-A-2006/094645

## Description

### Field of Invention

The invention relates to a process for coupling thiophene or selenophene derivatives, in particular for preparing conjugated thiophene or selenophene polymers with high molecular weight and high regioregularity, and to novel polymers prepared by this process. The invention further relates to the use of the novel polymers as semiconductors or charge transport materials in optical, electrooptical or electronic devices including field effect transistors (FETs), thin film transistors (TFT), electroluminescent, photovoltaic and sensor devices. The invention further relates to FETs and other semiconducting components or materials comprising the novel polymers.

### Background and Prior Art

Organic materials have shown promise as the active layer in organic based thin film transistors and organic field effect transistors (OFETs). Such devices have potential applications in smart cards, security tags and the switching element in flat panel displays. Organic materials are envisaged to have substantial cost advantages over their silicon analogues if they can be deposited from solution, as this enables a fast, large-area fabrication route.

The performance of the device is principally based upon the charge carrier mobility of the semiconducting material and the current on/off ratio, so the ideal semiconductor should have a low conductivity in the off state, combined with a high charge carrier mobility (> 1 x 10⁻³ cm² V⁻¹ S⁻¹). In addition, it is important that the semiconducting material is relatively stable to oxidation i.e. it has a high ionisation potential, as oxidation leads to reduced device performance.

A suitable semiconducting material known from prior art is regioregular head-to-tail (HT) poly-(3-alkylthiophene) (P3AT), such as poly-(3-hexylthiophene) (P3HT). It shows a high charge carrier mobility, a good solubility in organic solvents, and is solution processable to fabricate large area films.

The synthesis of regioregular polythiophene is well reported in the literature by a variety of methods including Grignard metathesis [1], Rieke coupling [2], Stille coupling [3], and Suzuki coupling [4]. Further methods can be used to obtain regioregular polythiophenes only when the monomer employed is symmetrical, namely Yamamoto coupling [5] and oxidative polymerisation [6]. However, these methods currently suffer from some drawbacks, particularly when synthesising copolymers comprising of at least two thiophene-based monomers.

The Grignard metathesis, Rieke coupling, Yamamoto coupling, and oxidative polymerisation methods are all only applicable to the synthesis of regioregular homopolymers based upon a single monomer unit. These synthetic approaches are therefore not applicable to the preparation of alternating copolymers. Furthermore, the Grignard metathesis so far has proven to be useful only for the synthesis of P3AT.

On the other hand, the Stille and Suzuki coupling methods are amenable to the preparation of both regioregular homopolymers and alternating copolymers, but yet each suffers from a critical obstacle.

In the case of the Stille coupling, a main obstacle is the toxicity of organotin compounds. Typically either tributylstannyl or trimethylstannyl thiophene derivatives are employed in the polymerisation. These monomers are prepared from a trialkyltin halide, in particular trimethyltin halide, which is highly toxic. The trialkyltin halide is also re-generated during the polymerisation. The toxicity issue is disadvantageous especially in the large-scale preparation of polythiophenes via this route.

For the Suzuki coupling, the current obstacles are the low molecular weight polythiophenes obtained [7] and/or the low yields [4,7]. This is due to significant deboronation of thiophene boronate esters/acids occurring during the reaction [7], which typically limits the molecular weights obtained.

The molecular weights of polythiophenes have a direct effect on their thin-film morphology and consequently on their field-effect mobility as observed for P3HT [8]. In addition, it was reported that the performance of (bulk heterojunction) solar cells depends on the molecular weights of P3HT used in the device [9]. Thus, it is critical to be able to synthesise high molecular weight polythiophenes, in order for them to be an attractive candidate for application in electronic devices, such as FETs and solar cells.

The prior art [10, 11, 12] also discloses Suzuki coupling methods that yield high molecular weight polymers (Mₙ > 100,000 Da) in good yields, for example for 9,9-dialkylfluorene based copolymers. However, these methods do not yield polythiophenes with high molecular weights and in high yields.

Therefore, there is still a need for an improved method of preparing thiophene polymers with high regioregularity, high molecular weight, high purity and high yields in an economical, effective and environmentally beneficial way, which is especially suitable for industrial large scale production.

It is an aim of the present invention to provide an improved process for preparing thiophene polymers with these advantages, but not having the drawbacks of prior art methods mentioned above. Other aims of the present invention are immediately evident to the person skilled in the art from the following detailed description.

It was found that these aims can be achieved with a process as claimed in the present invention. This process enables coupling thiophene and selenophene compounds and is especially suitable for synthesising conjugated polymers of thiophene or selenophene with high molecular weight and high regioregularity. The polymers obtianed by this process are to useful as semiconducting component especially in the fabrication of FETs and TPTs.

EP 1 510 535 A1, WO 2005/111045 A1 and WO 2006/021277 A1 disclose polythieno thiophenes, but do not disclose a process as claimed in claim 1.

### Summary of the Invention

The invention relates to a process for polymerising a heteroaromatic compound under formation of aryl-aryl C-C couplings, wherein said compound has at least one functional halide group and at least one functional boron group, or copolymerising at least one first and at least one second heteroaromatic compound under formation of aryl-aryl C-C couplings, wherein said first compound has at least two functional halide groups and said second compound has at least two functional boron groups, wherein the polymerisation is carried out in presence of
a) a catalyst/ligand system comprising a palladium catalyst and an organic phosphine or phosphonium compound,
b) a base,
c) a solvent or a mixture of solvents,
characterized in that
the functional halide and boron groups are attached to a thiophene or selenophene ring that is optionally substituted and optionally fused to another ring, and
the organic phosphine or phosphonium compound is a trisubstituted phosphine or phosphonium salt with substituents selected from optionally substituted alkyl and aryl groups, and the organic phosphine compound is formed in situ from the corresponding phosphonium salt during the process by the addition of the base.

The polymers, according to the present invention can be used as charge-transport, semiconducting, electrically conducting, photoconducting or light-emitting material in optical, electrooptical, electronic semiconducting or electroluminescent (EL) components or devices, organic field effect transistors (OFET), integrated circuits (IC), thin film transistors (TFT), flat panel displays, radio frequency identification (RFID) tags, electroluminescent or photoluminescent devices or components, organic light emitting diodes (OLED), backlights of displays, photovoltaic or sensor devices, charge injection layers, Schottky diodes, planarising layers, antistatic films, conducting substrates or patterns, electrode materials in batteries, photoconductors, electrophotographic applications, electrophotographic recording, organic memory devices, alignment layers, cosmetic or pharmaceutical compositions, biosensors, biochips, security markings, polymerisable liquid crystal materials, liquid crystal polymers, anisotropic polymer films with charge transport properties or methods or devices for detecting and discriminating DNA sequences.

### Detailed Description of the Invention

Above and below, the term "functional group" refers to a group which is capable of reacting in a Suzuki coupling reaction with another group to produce an aryl-aryl C-C bond. The functional groups are selected from a first type A which is, for example, a halide group, and a second type B which is, for example, a boron group. Compounds having one such functional group (of type A or B) attached to an aromatic core are also referred to as "monofunctional compounds". Compounds having two or more of such functional groups (of type A and/or B) attached to an aromatic core are also referred to as "di- or multifunctional compounds". Di- or multifunctional compounds can comprise the same or different types of functional groups and are accordingly referred to as "AA-, BB-, AB-type compounds".

The term "functional halide group" means a group preferably selected from halogen or a sulfonyloxy group. Very preferred halide groups are Cl, Br, I or a sulfonyloxy group of the formula -OSO₂R^{x}, wherein R^{x} is optionally fluorinated alkyl or aryl, preferably having 1 to 12 C atoms like for example methyl, trifluoromethyl or 4-methylphenyloxy, so that the sulfonyloxy group is accordingly mesylate, triflate or tosylate. Especially preferred are Br or I.

The term "functional boron group" means a boronic acid, boronic acid ester (boronate) or borane group. The boron group is preferably of the formula -B(OR')(OR"), wherein R' and R" are independently of each other H or alkyl with 1 to 12 C-atoms, or R' and R" together form an optionally substituted cyclic aliphatic or aromatic group, especially an alkylene or arylene group having 2 to 20 C atoms. Especially preferred groups are selected from boronic acid, boronic acid esters of monofunctional C₁-C₆ alcohols, or boronic acid esters of difunctional alcohols like ethanediols, pinacol, propane diols or ortho aromatic diols like 1,2-dihydroxybenzene. The borane group is preferably of the formula -BR'R", wherein R' and R" are as defined above. Very preferred are the following groups

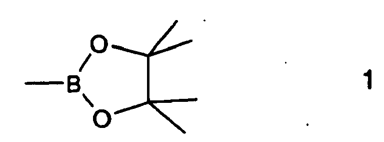

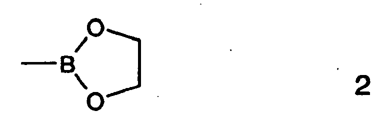

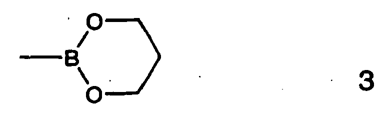

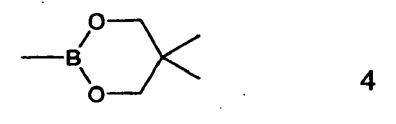

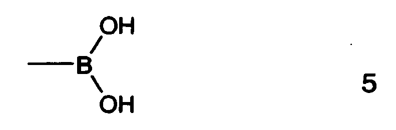

The thiophene or selenophene compounds that are used as monomers in the process according to the present invention are preferably selected of formula I

X¹-(Ar¹)ₐ-(Ar²)_{b}-(Ar³)_{c}-X² I

wherein
- Ar¹ and Ar³: are, in case of multiple occurrence independently of one another, identical or different arylene or heteroarylene groups, which are optionally substituted with one or more groups R, optionally comprise fused rings, and comprise a thiophene ring or a selenophene ring linked to X¹ and/or X², respectively,
- Ar²: is, in case of multiple occurrence independently of one another, an arylene or heteroarylene group that is optionally substituted with one or more groups R and optionally comprises fused rings,
- a and c: are independently of each other 1, 2 or 3, and, in case b is 0, one of a and c may also be 0,
- b: is 0, 1, 2, 3 or 4,
- X¹ and X²: are independently of each other a functional halide group or a functional boron group,
- R: in case of multiple occurrence independently of one another has one of the meanings of X¹ or is aryl, heteroaryl, aryloxy or heteroaryloxy, which is optionally substituted by one or more groups L, or straight chain, branched or cyclic alkyl with 1 to 20 C-atoms, which is optionally mono- or polysubstituted by F, Cl, Br or I, and wherein one or more non-adjacent CH₂ groups are optionally replaced, in each case independently from one another, by -O-, -S-, -NR⁰-, -SiR⁰R⁰⁰-, -CY¹=CY²- or - C≡C- in such a manner that O and/or S atoms are not linked directly to one another, or is selcted from F, Cl, CN, NO₂, NR⁰R⁰⁰, -SiR⁰R⁰⁰R⁰⁰⁰, -C≡C-SiR⁰R⁰⁰R⁰⁰⁰ or sulfonyl
- L: is F, Cl, Br, I, CN, NO₂, NR⁰R⁰⁰, -SiR⁰R⁰⁰R⁰⁰⁰, -C≡C- SiR⁰R⁰⁰R⁰⁰⁰, sulfonyl, or straight chain, branched or cyclic alkyl having 1 to 20 C atoms, which is unsubstituted, mono- or poly-substituted by F, Cl, Br, I, - CN or -OH, and in which one or more non-adjacent CH₂ groups are optionally replaced, in each case independently from one another, by -O-, -S-, -NH-, - NR°-, -SiR⁰R⁰⁰-, -CO-, -COO-, OCO-, -OCO-O, -S-CO-, -CO-S-,-CH=CH- or -C=C- in such a manner that O and/or S atoms are not linked directly to one another,
- Y¹ and Y²: are independently of each other H, F or Cl,
- R⁰, R⁰⁰ and R⁰⁰⁰: are independently of each other H, alkyl with 1 to 12 C-atoms or aryl.

In case of a process where one compound is polymerised, it is preferably selected of formula I wherein X¹ is a halide group (AB-type).

In case of a process where a first and a second compound are copolymerised, the first compound is preferably selected of formula I wherein X¹ and X² are a halide group (AA-type), and the second compound is preferably selected of formula I wherein X¹ and X² are a boron group (BB-type).

Ar¹ and Ar³ in formula I are preferably selected from
a) thiophene-2,5-diyl (A1), selenophene-2,5-diyl (A2) or thieno[2,3-b]thiophene-2,5-diyl (A3), 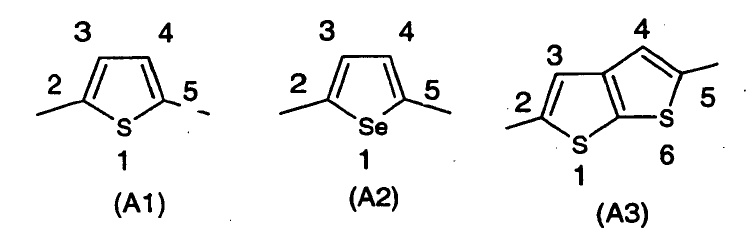 which are optionally substituted in 3- and/or 4-position with R,
b) thieno[3,2-b]thiophene-2,5-diyl (A4), 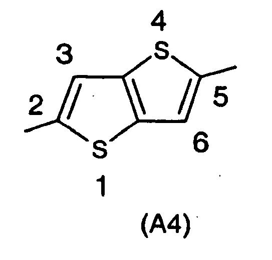 which is optionally substituted in 3- and/or 6-position with R,
c) benzo[1,2-b:4,5-b'] dithiophene-2,6-diyl (A5) 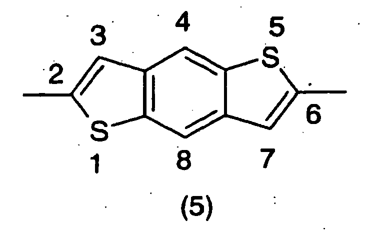 which is optionally substituted in 3-, 4- 7- or 8-position with R.

Ar² in formula I is preferably a mono-, bi- or tricyclic aromatic or heteroaromatic group with up to 25 C atoms, wherein the rings can be fused, and in which the heteroaromatic group contains at least one hetero atom preferably selected from N, O and S. It is optionally substituted with one or more groups L, with L being selected from F, Cl, Br, I, CN, and straight chain, branched or cyclic alkyl having 1 to 20 C atoms, which is unsubstituted, mono- or poly-substituted by F, Cl, Br, I, -CN or -OH, and in which one or more non-adjacent CH₂ groups are optionally replaced, in each case independently from one another, by -O-, -S-, -NH-, -NR⁰-, -SiR⁰R⁰⁰-, -CO-, -COO-, OCO-, - OCO-O, -S-CO-, -CO-S-,-CH=CH- or -C≡C- in such a manner that O and/or S atoms are not linked directly to one another.

Preferred arylene or heteroarylene groups Ar² are selected from phenylene in which, in addition, one or more CH groups may be replaced by N, or naphthalene, alkyl fluorene, oxazole, thiophene, selenophene, dithienothiophene, wherein all these groups are optionally mono- or polysubstituted with L as defined above. Further preferred arylene or heteroarylene groups Ar² are 1,4-phenylene-1,4-diyl, pyridine-2,5-diyl, pyrimidine-2,5-diyl, 1,1'-biphenyl-4,4'-diyl, naphthalene-2,6-diyl, thiophene-2,5-diyl, selenophene-2,5-diyl, thiophene-2,5-diyl or selenophene-2,5-diyl, fluorene-2,7-diyl, 2,2'-dithiophene-5,5'-diyl, thieno[2,3-b]thiophene-2,5-diyl, thieno[3,2-b]thiophene-2,5-diyl, benzo[1,2-b:4,5-b']dithiophene-2,6-diyl, thiazole-2,5-diyl, thiadiazole-2,5-diyl, thieno[2,3-d]thiazole-4,6-diyl, thieno[2,3-d]thiazole-6,4-diyl, oxazole-2,5-diyl and oxadiazole-2,5-diyl, all of which are unsubstituted, or optionally fluorinated, alkylated, or mono- or polysubstituted with L as defined above.

Especially preferred are the following compounds of formula I
- b is 0,
- a+c is 1, 2 or 3 and Ar¹ and Ar³ are selected from thiophene-2,5-diyl that is optionally substituted in 3- and/or 4-position,
- a+c is 1, 2 or 3 and Ar¹ and Ar³ are selected from selenophene-2,5-diyl that is optionally substituted in 3- and/or 4-position,
- a+c is 1 and Ar¹, or Ar³ respectively, is thieno[2,3-b]thiophene-2,5-diyl that is optionally substituted in 3- and/or 4-position,
- a+c is 1 and Ar¹, or Ar³ respectively, is thieno[3,2-b]thiophene-2,5-diyl that is optionally substituted in 3- and/or 6-position,
- a+c is 1 and Ar¹, or Ar³ respectively, is benzo[1,2-b:4,5-b']dithiophene-2,6-diyl that is optionally substituted in 3- and/or 6-position,
- if X¹ and/or X² are halogen they are selected from Br and I,
- R is straight chain, branched or cyclic alkyl, alkenyl, alkynyl, alkoxy, oxaalkyl, alkylcarbonyl, alkoxycarbonyl, alkylcarbonyloxy, thioalkyl, alkylsilyl or dialkylamino with 1 to 20 C-atoms that is optionally substituted with one or more fluorine atoms, or aryl or heteroaryl.

The AA-type compounds are preferably selected of formulae I1a-I1f.

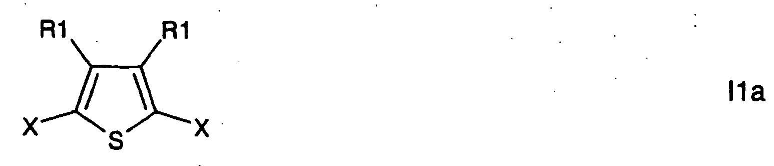

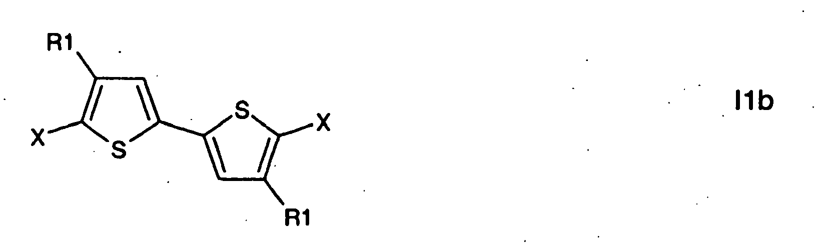

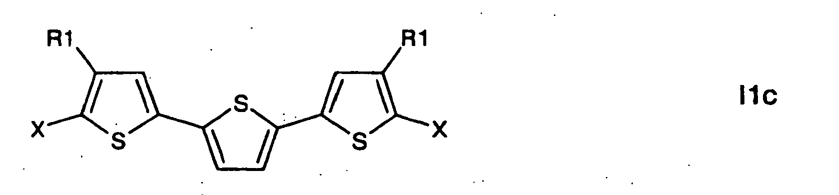

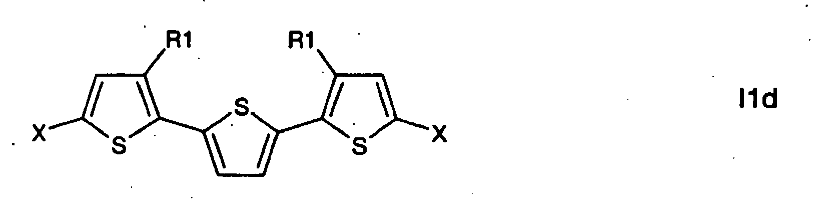

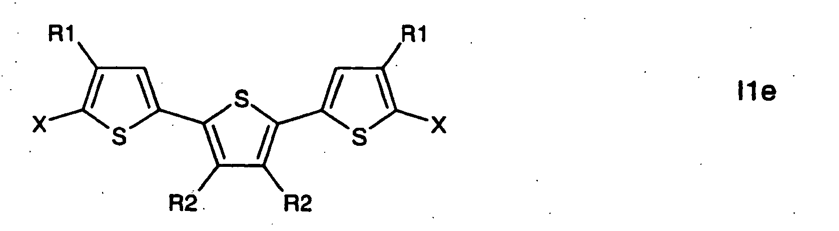

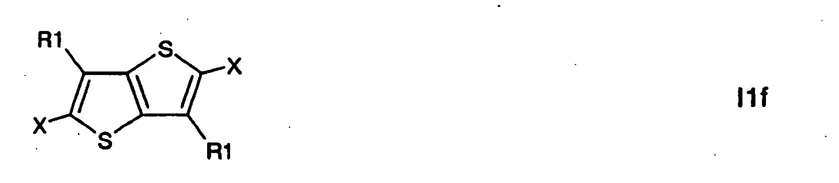

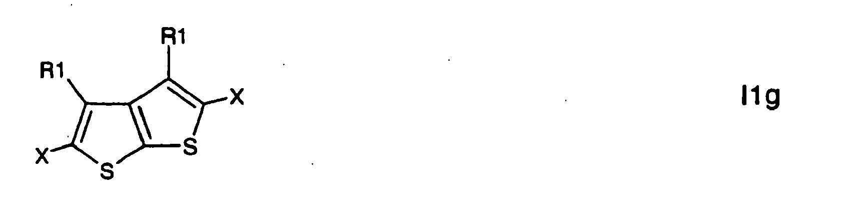

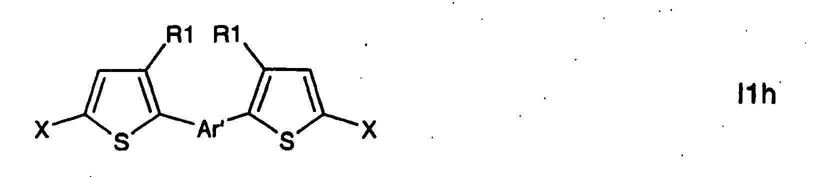

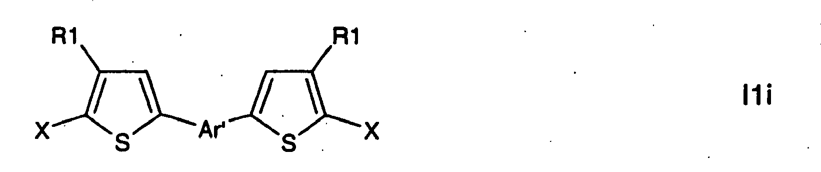

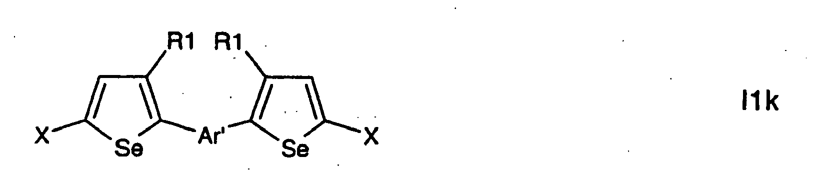

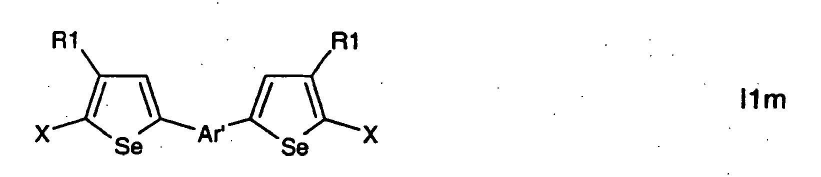

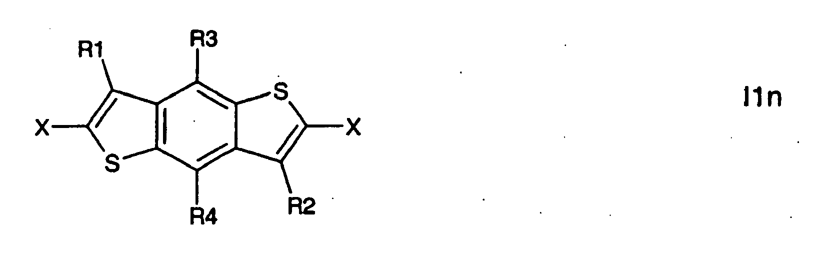

The BB-type compounds are preferably selected of formulae I2a-I2f. 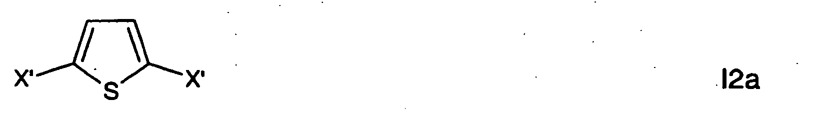 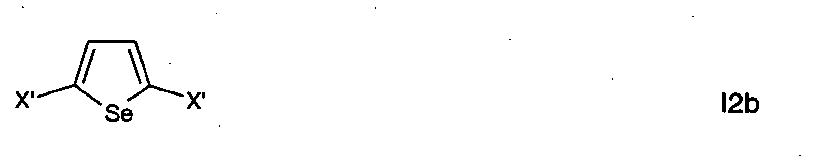 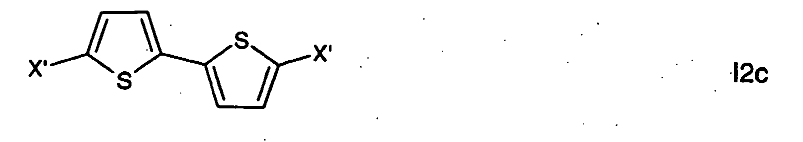 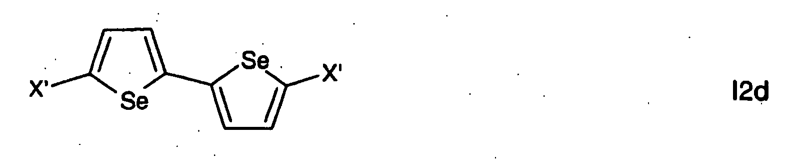 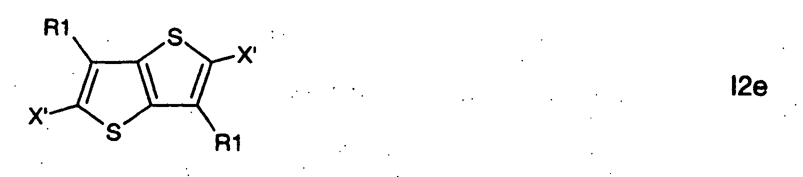 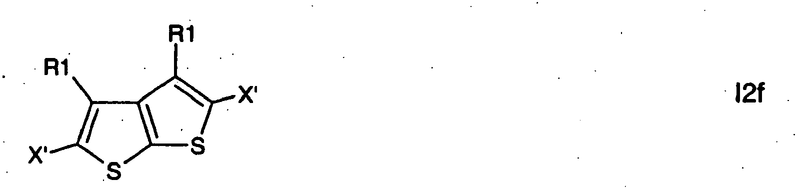 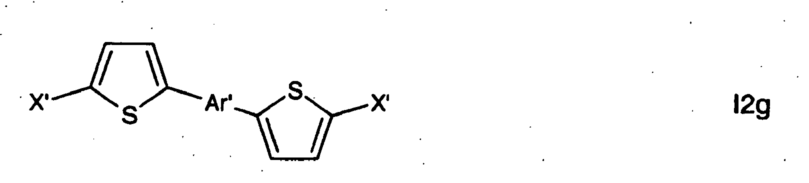 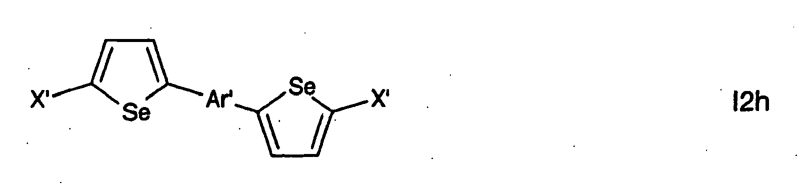 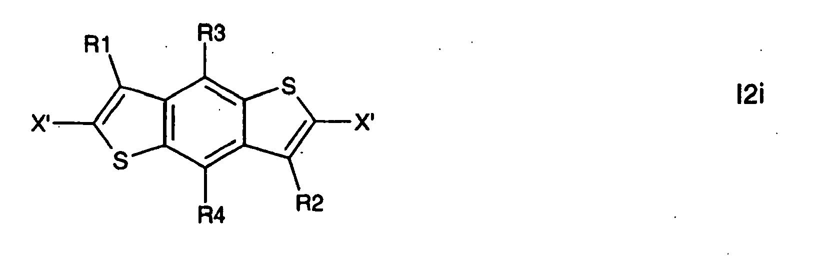 wherein
- Ar': has one of the meanings for Ar²,
- X: is a halide group as defined above and below,
- X': is a boron group as defined above and below, and
- R¹⁻⁴: have independently of each other one of the meanings of R in formula I.

The AB-type compounds are preferably selected of the following formulae 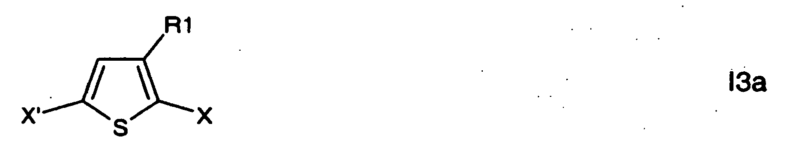 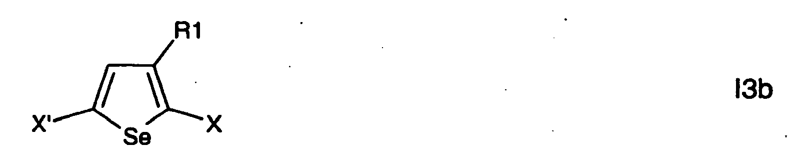 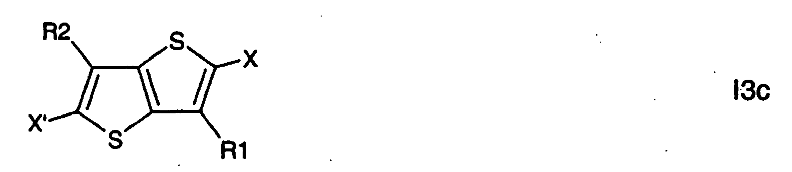 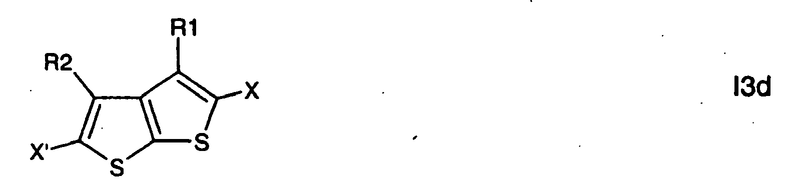 wherein
- X: is a halide group as defined above and below,
- X': is a boron group as defined above and below, and
- R¹ and R²: have independently of each other one of the meanings of R in formula I.

In the compounds of formula I and the preferred subformulae, R, R¹ and R² are preferably identical or different groups selected from straight chain, branched or cyclic alkyl, alkenyl, alkynyl, oxaalkyl, alkoxy, alkoxycarbonyl, alkylcarbonyloxy, thioalkyl, alkylsilyl or dialkylamino with 1 to 20 C-atoms that is optionally substituted with one or more fluorine atoms, or aryl or heteroaryl.

If R, R¹ or R² is aryl or heteroaryl, it is preferably a mono-, bi- or tricyclic aromatic or heteroaromatic group with up to 25 C atoms that optionally comprises fused rings and is optionally substituted with one or more groups L, wherein L is as defined above.

If R, R¹ or R² is an alkyl group it may be straight-chain or branched. It is preferably straight-chain, has 4 to 16 C -atoms carbon atoms and accordingly is preferably methyl, ethyl, propyl, butyl, pentyl, hexyl, heptyl, octyl, nonyl, decyl, undecyl, dodecyl, tridecyl, tetradecyl, pentadecyl, or hexadecyl for example.

If R, R¹ or R² is an alkyl group wherein one or more CH₂ groups are replaced by -CH=CH-, this may be straight-chain or branched. It is preferably straight-chain, has 2 to 10 C-atoms and accordingly is preferably vinyl, prop-1-, or prop-2-enyl, but-1-, 2- or but-3-enyl, pent-1-, 2-, 3- or pent-4-enyl, hex-1-, 2-, 3-, 4- or hex-5-enyl, hept-1-, 2-, 3-, 4-, 5- or hept-6-enyl, oct-1-, 2-, 3-, 4-, 5-, 6- or oct-7-enyl, non-1-, 2-, 3-, 4-, 5-, 6-, 7- or non-8-enyl, dec-1-, 2-, 3-, 4-, 5-, 6-, 7-, 8- or dec-9-enyl.

R, R¹ or R² can also be a chiral group like for example 2-butyl (=1-methylpropyl), 2-methylbutyl, 2-methylpentyl, 3-methylpentyl, 2-ethylhexyl, 2-propylpentyl, 4-methylhexyl, 2-hexyl, 2-octyl, 2-nonyl, 2-decyl, 2-dodecyl, 1,1,1-trifluoro-2-octyl, 1,1,1-trifluoro-2-hexyl or an achiral branched group like for example isopropyl, isobutyl (=methylpropyl) or isopentyl (=3-methylbutyl).

If R, R¹ or R² is an alkoxy group where the terminal CH₂ group (i.e. the one linked to the aromatic ring) is replaced by -O-, this may be straight-chain or branched. It is preferably straight-chain, has 2 to 16 carbon atoms and accordingly is preferably ethoxy, propoxy, butoxy, pentoxy, hexyloxy, heptoxy, or octoxy, furthermore nonoxy, decoxy, undecoxy, dodecoxy, tridecoxy, tetradecoxy, pentadecoxy or hexadecoxy for example.

If R, R¹ or R² is oxaalkyl where one CH₂ group is replaced by -O-, is preferably straight-chain 2-oxapropyl (=methoxymethyl), 2-oxabutyl (=ethoxymethyl) or 3-oxabutyl (=2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.

In another preferred embodiment R, R¹ or R² is oxaalkyl wherein two or more non-adjacent CH₂ groups are replaced by -O-, like for example 1,4-dioxahexyl, 3,6-dioxaoctyl, 5,8-dioxadecyl or 7,10-dioxadodecyl.

If R, R¹ or R² is thioalkyl where one CH₂ group is replaced by -S-, is preferably straight-chain thiomethyl (-SCH₃), 1-thioethyl (-SCH₂CH₃), 1-thiopropyl (= -SCH₂CH₂CH₃), 1- (thiobutyl), 1-(thiopentyl), 1-(thiohexyl), 1-(thioheptyl), 1-(thiooctyl), 1-(thiononyl), 1-(thiodecyl), 1-(thioundecyl) or 1-(thiododecyl), wherein preferably the CH₂ group adjacent to the sp² hybridised vinyl carbon atom is replaced.

If R, R¹ or R² is fluoroalkyl, it is preferably straight-chain perfluoroalkyl CᵢF₂ᵢ₊₁, wherein i is an integer from 1 to 15, in particular CF₃, C₂F₅, C₃F₇, C₄F₉, C₅F₁₁, C₆F₁₃, C₇F₁₅ or C₈F₁₇, very preferably C₆F₁₃.

-CY¹=CY²- is preferably -CH=CH-, -CF=CF- or -CH=C(CN)-.

Preferred aryl and heteroaryl groups are phenyl in which, in addition, one or more CH groups are optionally replaced by N, benzyl, biphenyl, naphthalene, thiophene, selenophene, thienothiophene, dithienothiophene, fluorene, benzo[1,2-b:4,5-b']dithiophene, thiazole and oxazole, all of which can be unsubstituted, mono- or polysubstituted with L as defined above.

Especially preferred aryl and heteroaryl groups are selected from phenyl, pyridine, pyrimidine, naphthalene, thiophene, selenophene, thienothiophene, fluorene, thiazole and oxazole, all of which are unsubstituted, mono- or polysubstituted with L as defined above.

L is preferably selected from F, Cl, Br, I, alkyl, alkoxy, alkylcarbonyl, alkoxycarbonyl, alkylcarbonyloxy or thioalkyl with 1 to 20 C atoms, wherein one or more H atoms are optionally substituted by F or Cl.

The process according to this invention is especially suitable as a polymerisation method for thiophene and selenophenes to yield conjugated polymers or copolymers with high molecular weight (Mₙ > 20,000 Da) in high yields. It is based upon the palladium-catalysed Suzuki coupling and employs a highly active catalyst/ligand system, using a palladium(0) or palladium(II) catalyst and a trialkylphosphine or a trialkylphosphonium salt, or a mixed trisubstituted phosphine or phosphonium salt that is substituted with alkyl and aryl groups. The high activity of the catalyst/ligand system enables a high molecular weight polymer to be formed before significant deboronation occurs.

As previously mentioned, the problem with current Suzuki methodology is that high molecular weight polythiophenes cannot be obtained due to deboronation. Thiophene boronate esters/acids are particularly sensitive to deboronation. In contrast, by using a catalyst/ligand system with higher activity i.e higher coupling rate as claimed in the present invention, many aryl-aryl couplings can occur before significant deboronation (side-reaction) takes place, allowing high molecular weight polythiophenes to be obtained.

Trialkylphosphines are more reactive ligands than triarylphosphines due to their higher electron richness and sterics [13]. However, they are not air-stable and tend to readily oxidise to phosphine oxide products. Furthermore, some of them, such as tri-*tert-*butylphosphine, are pyrophoric. However, this invention describes a solution to these handling and stability issues, namely the use of a robust air-stable trialkylphosphonium salt or a mixed alkyl-/arylphosphonium salt from which the active phosphine is generated 'in-situ' by addition of a base [13].

The preparation of trialkylphosphonium salts and their use in Suzuki couplings has previously been reported by Fu *et* al [13]. Some trialkylphosphonium or alkyl-/arylphosphonium salts, such as tri-*tert-*butylphosphonium tetrafluoroborate, are now commercially available.

By using a phosphine-free palladium(0) catalyst (e.g. Pd₂(dba)₃) in conjunction with a trialkylphosphine or trialkylphosphonium salt, or with a mixed alkyl-/arylsubstituted phosphine or phosphonium salt, a large range of polythiophenes is accessible with Suzuki methodology (see Scheme 1). 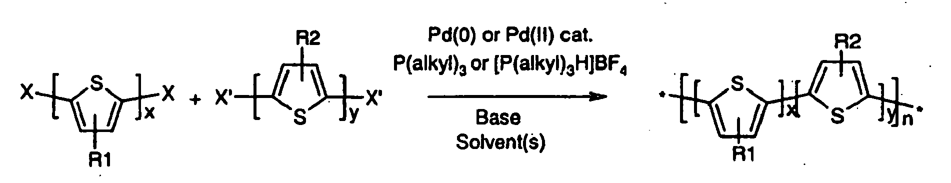 where X = halide; X' = boron group; R1, R2 = alkyl or H; x, y = 1,2,3,4,5

Furthermore, it is also possible to use phosphine-free palladium(II) catalysts (e.g. Pd(OAc)₂) in conjunction with either a trisubstituted phosphine or phosphonium salt, or a palladium(II)-trisubstitutedphosphine complex (e.g. PdCl₂(PCy₃)₂). The palladium(II) species are then reduced 'in-situ' to the active palladium(0) species.

Prior art [14] also discloses a process for preparing aryl-aryl compounds using Suzuki coupling with a palladium(0) or palladium(II) catalyst with various ligands, except triphenylphosphine. However, it is not disclosed or suggested that trialkylphosphines or alkyl/arylsubstituted phosphines are especially suitable, or that the corresponding phosphonium salts can be used, or that the process is suitable for the preparation of polythiophenes or polyselenophenes with high molecular weight.

With the process according to the present invention it is possible for example to copolymerise an AA-type compound and a BB-type compound having the same core, or to polymerise an AB-type compound. Thereby regioregular homopolymers can be formed.

It is also possible for example to copolymerise one AA-type compound and one BB-type compound having different cores. Thereby alternating copolymers can be formed.

It is also possible for example to copolymerise a mixture of two or more AA-type compounds having different cores and/or two or more BB-type compounds having different cores, or to copolymerise a mixture of two or more AB-type compounds with different cores. Thereby statistical or random copolymers can be formed.

It is also possible to carry out the polymerisation in different steps. For example, it is possible to react an AA-type compound with a BB-type compound having a given core in a first polymerisation step, and to add an AA-type compound and/or a BB-type compound with a different core for a second polymerisation step. Alternatively, it is possible to react a first AB-type compound in a first polymerisation step and to add a second AB-type compound having a different core for a second polymerisation step. Thereby block copolymers can be formed.

It is also possible for example to polymerise multifunctional compounds having more than two functional groups. Thereby crosslinked polymers can be formed. Suitable multifunctional compounds are for example compounds of formula I wherein Ar is substituted with one or more groups R having the meaning of X¹.

It is also possible to add monofunctional compounds (A-type or B-type), also known as "endcappers", to the reaction mixture, in order to control or limit the degree of polymerisation and molecular weight of the polymer, and to react with any remaining functional endgroups in the polymer such as halides or boronates.

The catalyst/ligand system (component a) comprises a palladium catalyst and an organic trisubstituted phosphine or phosphonium salt.

The palladium catalyst is preferably a Pd(0) or Pd(II) compound or metallic Pd. Suitable and preferred Pd compounds are for example Pd(II) salts or organic Pd(0) compounds or complexes. Very preferred are Pd(II) halides, Pd(II) carboxylates and Pd(II)β-diketonates. Examples of preferred catalysts include the following compounds
- Pd₂(dba)₃: [tris(dibenzylideneacetone) dipalladium(0)],
- Pd(dba)₂: [bis(dibenzylideneacetone) palladium (0)],
- Pd(PR'₃)₂: [bis(trialkylphosphine) palladium(0), wherein R' is alkyl that is straight-chain, branched or cyclic and has preferably 1 to 12 C atoms, or aryl with 4 to 20 C atoms that is optionally substituted, preferably alkyl, like for example bis(tri-tert-butylphosphine)palladium(0)],
- Pd(OAc)₂: [palladium(II) acetate],
- PdCl₂(PR'₃)₂: [dichlorobis(trialkylphosphine) palladium(II), wherein R' is alkyl or aryl as defined above, preferably alkyl, like for example dichlorobis(tricyclohexylphosphine) palladium(II)],
- PdCl₂(PhCN)₂: [dichlorobis(benzonitrile) palladium(II),
- PdCl₂(CH₃CN): [dichlorobis(acetonitrile) palladium(II)], or
- PdCl₂(cod): [dichloro(1,5-cyclooctadiene) palladium(II)].

Most preferred are Pd₂(dba)₃, Pd(dba)₂, Pd(OAc)₂ or Pd(PR'₃)₂.

The phosphine compound is an organic trisubstituted phosphine ligand that is capable of coordinating to the Pd atom. The phosphine ligand is formed in situ from the corresponding phosphonium salt during the process by the addition of base.

Preferred phosphine ligands are selected from the formula R^{a}ₓR^{b}_{y}R^{c}_{z}P, wherein
P denotes phosphorus,
R^{a}, R^{b} and R^{c} are identical or different straight-chain, branched or cyclic alkyl groups with 1 to 12 C atoms that are optionally fluorinated, or aryl groups with 4 to 20 C atoms that are optionally substituted,
x, y and z are 0, 1, 2 or 3, with x+y+z = 3,

Preferably the organic phosphine or phosphonium salt comprises at least one substituent R^{a}, R^{b}, R^{c} that is an alkyl group as defined above.

Especially preferred are ligands of the formula R^{a}₃P wherein all groups R^{a} are identical. Further preferred are ligands of the formula R^{a}₂R^{b}P or R^{a}R^{b}₂P, wherein R^{a} and R^{b} are different. Further preferred are ligands wherein R^{a} and R^{b} are alkyl as defined above, and ligands wherein R^{a} is an alkyl group and R^{b} an aryl group as defined above. Preferred alkyl and aryl groups are those as defined above for R.

Examples of preferred ligands are triethylphosphine, tri-iso-propyl-phosphine, tri-cyclohexylphosphine, tri-tert-butylphosphine (*t*-Bu), bis(di-tert-butylphosphino)methane and 2-dicyclohexylphosphino-2',6'-dimethoxybiphenyl.

Preferred phosphonium salts are selected from the formula [R^{a}ₓR^{b}_{y}R^{c}_{z}PH]⁺Z⁻ wherein R^{a-c} and x, y and z are as defined above and Z- is a suitable anion, like for example BF₄⁻, PF₆⁻ or SbF₆⁻. Especially preferred are the corresponding phosphonium salts, for example phosphonium tetrafluoroborates, of the above mentioned preferred phosphine ligands.

Most preferred are *t*-Bu₃P and [*t*-Bu₃PH]BF₄.

The palladium catalyst is present in the reaction mixture in catalytic amounts. The term "catalytic amount" as used above and below refers to an amount that is clearly below one equivalent of the heteroaromatic compound(s), preferably 0.01 to 5 mol. %, most preferably 0.01 to 1 mol. %, based on the equivalents of the heteraromatic compound(s) used.

The amount of phosphines or phosphonium salts in the reaction mixture is preferably from 0.02 to 10 mol. %, most preferably 0.02 to 2 mol. %, based on the equivalents of the heteraromatic compound(s) used. The preferred ratio of Pd:phosphine is 1:2.

The base (component b) can be selected from all aqueous and nonaqueous bases. It is preferable that at least 1.5 equivalents of said base per functional boron group is present in the reaction mixture. Suitable and preferred bases are, for example, alkali and alkaline earth metal hydroxides, carboxylates, carbonates, fluorides and phosphates such as sodium and potassium hydroxide, acetate, carbonate, fluoride and phosphate or also metal alcoholates, preferably corresponding phosphates or carbonates. It is also possible to use a mixture of bases. Most preferred is aq. K₂CO₃ or aq. Na₂CO₃.

The solvent (component c) is for example selected from toluene, xylenes, anisole, THF, 2-methyltetrahydrofuran, dioxane, chlorobenzene, fluorobenzene or solvent mixtures comprising one or more solvents like e.g. THF/toluene. Most preferred is THF or THF/toluene.

For polymerisations that are performed in a single solvent or a solvent mixture, it is possible to add a secondary or tertiary co-solvent once the polymerisation has initiated and after a given period of time. The purpose of this co-solvent addition is to keep the growing polymer chains in solution during the polymerisation process. This also assist the recovery of the polymer from the reaction mixture at the end of the reaction and therefore improve the isolated yield of the polymer.

The polymer obtained by the process according to the present invention preferably has a degree of polymerisation of at least 20, more preferably at least 50, most preferably at least 100. Preferred molecular weights are at least 10,000 g mol⁻¹, more preferably at least 25,000 g mol⁻¹, most preferably at least 50,000 g mol⁻¹.

After polymerisation the polymer is preferably recovered from the reaction mixture, for example by conventional work-up, and purified. This can be achieved according to standard methods known to the expert and described in the literature.

Optionally the terminal groups of the polymer are chemically modified ('endcapped') during or after polymerisation.

Endcapping can be carried out for example by adding monofunctional compounds of formula I, or commercially available monofunctional compounds, for example bromobenzene, phenylboronic acid/boronate, 2-bromothiophene, and thiophene 2-boronic acid/boronate. Simple commercial monofunctional compounds are typically used, but monofunctional derivatives of formula I can also be used.

Endcapping can be carried out at the end of the reaction by addition of an 'endcapper' (*i.e.* a monofunctional compound of formula I or a commercial monofunctional compound). Alternatively, endcapping can be carried out 'in situ' by addition of a small quantity of 'endcapper' to the reaction mixture at the beginning of the reaction. The incorporation of an 'in situ' endcapper also controls the molecular weight of the polymer obtained, where the molecular weight obtained is dependent on the molar quantity of endcapper used.

Before recovering the polymer from the polymerisation reaction mixture, it may be preferable to add a co-solvent(s), for example toluene or chlorobenzene, to the reaction mixture in order to solubilise any precipitated polymer. The purpose of this is to aid the recovery of the polymer from the reaction mixture and therefore improve the isolated yield of the polymer.

The compounds and polymers prepared by the process according to the present invention can be used as semiconductors, which have high charge mobility, good processability and oxidative stability.

The compounds and polymers of the present invention are useful as optical, electronic and semiconductor materials, in particular as charge transport materials in field effect transistors (FETs), e.g., as components of integrated circuitry, ID tags or TFT applications. Alternatively, they may be used in organic light emitting diodes (OLEDs) in electroluminescent display applications or as backlight of, e.g., liquid crystal displays, as photovoltaics or sensor materials, for electrophotographic recording, and for other semiconductor applications.

The polymers according to the present invention show especially advantageous solubility properties which allow production processes using solutions of these compounds. Thus films, including layers and coatings, may be generated by low cost production techniques, e.g., spin coating. Suitable solvents or solvent mixtures comprise alkanes and/ or aromatics, especially their fluorinated or chlorinated derivatives.

The polymers of the present invention are especially useful as charge transport materials in FETs. Such FETs, where an organic semiconductive material is arranged as a film between a gate-dielectric and a drain and a source electrode, are generally known, e.g., from US 5,892,244, WO 00/79617, US 5,998,804, and from the references cited in the background and prior art chapter and listed below. Due to the advantages, like low cost production using the solubility properties of the compounds according to the invention and thus the processibility of large surfaces, preferred applications of these FETs are such as integrated circuitry, TFT-displays and security applications.

In security applications, field effect transistors and other devices with semiconductive materials, like transistors or diodes, may be used for ID tags or security markings to authenticate and prevent counterfeiting of documents of value like banknotes, credit cards or ID cards, national ID documents, licenses or any product with money value, like stamps, tickets, shares, cheques etc..

Alternatively, the polymers according to the invention may be used in organic light emitting devices or diodes (OLEDs), e.g., in display applications or as backlight of e.g. liquid crystal displays. Common OLEDs are realized using multilayer structures. An emission layer is generally sandwiched between one or more electron-transport and/or hole-transport layers. By applying an electric voltage electrons and holes as charge carriers move towards the emission layer where their recombination leads to the excitation and hence luminescence of the lumophor units contained in the emission layer.

The inventive compounds, materials and films may be employed in one or more of the charge transport layers and/ or in the emission layer, corresponding to their electrical and/ or optical properties. Furthermore their use within the emission layer is especially advantageous, if the polymers according to the invention show electroluminescent properties themselves or comprise electroluminescent groups or compounds. The selection, characterization as well as the processing of suitable monomeric, oligomeric and polymeric compounds or materials for the use in OLEDs is generally known by a person skilled in the art, see, e.g., Meerholz, Synthetic Materials, 111-112, 2000, 31-34, Alcala, J. Appl. Phys., 88, 2000, 7124-7128 and the literature cited therein.

According to another use, the polymers according to the present invention, especially those which show photoluminescent properties, may be employed as materials of light sources, e.g., of display devices such as described in EP 0 889 350 A1 or by C. Weder et al., Science, 279, 1998, 835-837.

A further aspect of the invention relates to both the oxidised and reduced form of the polymers according to this invention. Either loss or gain of electrons results in formation of a highly delocalised ionic form, which is of high conductivity. This can occur on exposure to common dopants. Suitable dopants and methods of doping are known to those skilled in the art, e.g., from EP 0 528 662, US 5, 198, 153 or WO 96/21659.

The doping process typically implies treatment of the semiconductor material with an oxidating or reducing agent in a redox reaction to form delocalised ionic centres in the material, with the corresponding counterions derived from the applied dopants. Suitable doping methods comprise for example exposure to a doping vapor in the atmospheric pressure or at a reduced pressure, electrochemical doping in a solution containing a dopant, bringing a dopant into contact with the semiconductor material to be thermally diffused, and ion-implantantion of the dopant into the semiconductor material.

When electrons are used as carriers, suitable dopants are for example halogens (e.g., I₂, Cl₂, Br₂, ICl, ICl₃, IBr and IF), Lewis acids (e.g., PF₅, AsF₅, SbF₅, BF₃, BCl₃, SbCl₅, BBr₃ and SO₃), protonic acids, organic acids, or amino acids (e.g., HF, HCl, HNO₃, H₂SO₄, HClO₄, FSO₃H and ClSO₃H), transition metal compounds (e.g., FeCl₃, FeOCl, Fe(ClO₄)₃, Fe(4-CH₃C₆H₄SO₃)₃, TiCl₄, ZrCl₄, HfCl₄, NbF₅, NbCl₅, TaCl₅, MoF₅, MoCl₅, WF₅, WCl₆, UF₆ and LnCl₃ (wherein Ln is a lanthanoid), anions (e.g., Cl⁻, Br⁻, I⁻, I₃⁻, HSO₄⁻, SO₄²⁻, NO₃⁻, ClO₄⁻, BF₄⁻, PF₆⁻, AsF₆⁻, SbF₆⁻, FeCl₄⁻, Fe(CN)₆³⁻, and anions of various sulfonic acids, such as aryl-SO₃⁻). When holes are used as carriers, examples of dopants are cations (e.g., H⁺, Li⁺, Na⁺, K⁺, Rb⁺ and Cs⁺), alkali metals (e.g., Li, Na, K, Rb, and Cs), alkaline-earth metals (e.g., Ca, Sr, and Ba), O₂, XeOF₄, (NO₂⁺) (SbF₆⁻), (NO₂⁺) (SbCl₆⁻), (NO₂⁺) (BF₄⁻), AgClO₄, H₂lrCl₆, La(NO₃)₃ 6H₂O, FSO₂OOSO₂F, Eu, acetylcholine, R₄N⁺, (R is an alkyl group), R₄P⁺ (R is an alkyl group), R₆As⁺ (R is an alkyl group), and R₃S⁺ (R is an alkyl group).

The conducting form of the polymers of the present invention can be used as an organic "metal" in applications, for example, but not limited to, charge injection layers and ITO planarising layers in organic light emitting diode applications, films for flat panel displays and touch screens, antistatic films, printed conductive substrates, patterns or tracts in electronic applications such as printed circuit boards and condensers.

According to another use the polymers according to the present invention, especially their water-soluble derivatives (for example with polar or ionic side groups) or ionically doped forms, can be employed as chemical sensors or materials for detecting and discriminating DNA sequences. Such uses are described for example in L. Chen, D. W. McBranch, H. Wang, R. Helgeson, F. Wudl and D. G. Whitten, Proc. Natl. Acad. Sci. U.S.A. 1999, 96, 12287; D. Wang, X. Gong, P. S. Heeger, F. Rininsland, G. C. Bazan and A. J. Heeger, Proc. Natl. Acad. Sci. U.S.A. 2002, 99, 49; N. DiCesare, M. R. Pinot, K. S. Schanze and J. R. Lakowicz, Langmuir 2002, 18, 7785; D. T. McQuade, A. E. Pullen, T. M. Swager, Chem. Rev. 2000, 100, 2537.

The compounds and materials according to the present invention can also be used in cosmetic or pharmaceutical compositions, for example in cosmetic compositions for hair treatment as disclosed in EP 1 498 112 A2.

### References:

1. R. S. Loewe, P. C. Ewbank, J. Liu, L. Zhai, R. D. McCullough, Macromolecules, 2001, 34, 4324.
2. T.-A. Chen, R. D. Rieke, J. Am. Chem. Soc., 1992, 114, 10087.
3. A. Iraqi, G. W. Barker, J. Mater. Chem., 1998, 8, 25*.*
4. S. Guillerez, G. Bidan, Synth. Met., 1998, 93, 123.
5. T. Yamamoto, A. Morita, Y. Miyazaki, T. Maruyama, H. Wakayama, Z. Zhou, Y. Nakamura, T. Kanbara, S. Sasaki, K. Kubota, K. Macromolecules, 1992, 25, 1214.
6. M. C. Gallazzi, C. Bertarelli, E. Montoneri, Synth. Met., 2002, 128, 91.
7. M. Jayakannan, J. L. J. van Dongen, R. A. J. Janssen, Macromolecules, 2001, 34, 5386.
8. J. R. Kline, M. D. McGehee, E. N. Kadnikova, J. Liu, J. M. J. Frechet, M. F. Toney, Macromolecules, 2005, 38, 3312
9. P. Schillinsky, U. Asawapirom, U. Scherf, M. Biele, C. J. Brabec, Chem. Mater., 2005, 17, 2175.
10. WO 99/20675 A1.
11. WO 00/53656 A1.
12. WO 03/035713 A1.
13. M. R. Netherton, G. C. Fu, Org. Lett., 2001, 3, 4295.
14. WO 03/048225 A2.

The examples below serve to illustrate the invention without limiting it. In the foregoing and the following, all temperatures are given in degrees Celsius, and all percentages are by weight, unless stated otherwise.

### Preparation of functional compounds

### Preparation of 2,5-bis(4,4,5,5-tetramethyl-1,3,2-dioxaborolan-2-yl)thieno[2,3-b]thiophene:

Thieno[2,3-*b*]thiophene (2.20 g, 15.69 mmol) is charged to a 3-necked RBF under nitrogen. Anhydrous THF (20 mL) is added. The stirred solution is cooled to -78°C. A 2.5M n-BuLi solution in hexanes (14 mL, 35.00 mmol) is added. The reaction mixture is warmed up to RT stirring for 18 h. The reaction mixture is cooled to -78°C and 2-isopropoxy-4,4,5,5-tetramethyl-1,3,2-dioxaborolane (6.42 g, 34.52 mmol) is added. The reaction mixture is warmed up to RT stirring for 8 h. The reaction mixture is poured into saturated aq. NH₄Cl solution (100 mL) and extracted into EtOAc (2 x 100 mL). The combined extracts is washed with water (100 mL) and brine (100 mL), dried over sodium sulfate, and concentrated in vacuo. The crude product is dissolved in DCM and filtered through a plug of silica and the filtrate is concentrated in vacuo. Recrystallisation from acetonitrile yielded the product as white plates (2.80 g, 45%): ¹H NMR (300 MHz, CDCl₃) δ 7.73 (s, 2H), 1.36 (s, 24H). ¹³C NMR (75 MHz, CDCl₃) 150.5, 150.3, 129.6, 84.2, 24.7.

### Preparation of 2,5-bis(4,4,5,5-tetramethyl-1,3,2-dioxaborolan-2-yl)thieno[3,2-b]thionhene:

Thieno[3,2-*b*]thiophene (2.20 g, 15.69 mmol) is charged to a 3-necked RBF under nitrogen. Anhydrous THF (20 mL) is added. The stirred solution is cooled to -50°C. A 2.5M n-BuLi solution in hexanes (14 mL, 35.00 mmol) is added. The reaction mixture is stirred at -50°C for 1 h. The reaction mixture is warmed up to RT stirring for 1 h. The reaction mixture is cooled to -50°C and 2-isopropoxy-4,4,5,5-tetramethyl-1,3,2-dioxaborolane (6.42 g, 34.52 mmol) is added. The reaction mixture is warmed up to RT stirring for 18 h. The reaction mixture is poured into saturated aq. NH₄Cl solution (100 mL) and extracted into DCM (2 x 100 mL). The combined extracts are washed with water (100 mL), dried over sodium sulfate, and concentrated in vacuo. The crude product is dissolved in DCM and filtered through a plug of silica and the filtrate is concentrated in vacuo. Recrystallisation from acetone yielded the product as white needles (1.55 g, 25%): ¹H NMR (300 MHz, CDCl₃) δ 7.76 (s, 2H), 1.36 (s, 24H). ¹³C NMR (75 MHz, CDCl₃) δ 146.6, 128.9, 84.4, 24.8.

### Preparation of 2-bromo-5-(4,4,5,5-tetramethyl-1,3,2-dioxaborolan-2-yl)-3-hexylthiophene:

2,5-Dibromo-3-hexylthiophene (2.00 g, 6.13 mmol) is charged to a 3-necked RBF under nitrogen. Anhydrous THF (50 mL) is added. The stirred solution is cooled to -78°C. A 2.5M n-BuLi solution in hexanes (2.5 mL, 6.25 mmol) is added. The reaction mixture is stirred at -78°C for 0.5 h. 2-Isopropoxy-4,4,5,5-tetramethyl-1,3,2-dioxaborolane (1.20 g, 6.45 mmol) is added. The reaction mixture is warmed up to RT stirring for 18 h. The reaction mixture is poured into saturated aq. NH₄Cl solution (100 mL) and extracted into EtOAc (3 x 50 mL). The combined extracts are washed with water (100 mL) and brine (100 mL), dried over sodium sulfate, and concentrated in vacuo. Column chromatography (eluent: petroleum ether 40-60: EtOAc, 10:1 to 4:1) yielded the product as a pale yellow oil (1.22, 53%): ¹H NMR (300 MHz, CDCl₃) δ 7.30 (s, 1 H), 2.55 (t, 2H, ³J = 8 Hz), 1.59 (m, 2H), 1.31 (m, 18H), 0.88 (t, 3H, ³J = 7 Hz). ¹³C NMR (75 MHz, CDCl₃) δ 143.4, 138.0, 116.4, 84.1, 31.6, 29.6, 29.3, 28.9, 24.7, 22.5, 13.9.

### Preparation of Polymers

### Example 1

The following polymer, poly(2,5-bis(3-decylthiophen-2-yl)thieno[2,3-b]thiophene), is prepared:

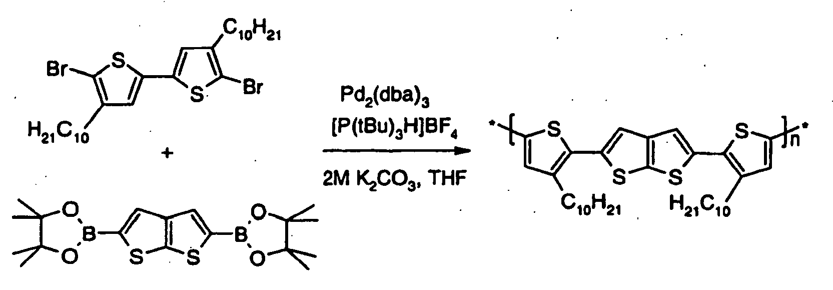

A 3-necked RBF is charged with 5,5'-dibromo-4,4'didecylthiophene (1.200 g, 1.985 mmol), 2,5-bis(4,4,5,5-tetramethyl-1,3,2-dioxaborolan-2-yl)thieno[2,3-b]thiophene (0.778 g, 1.985 mmol), tris(dibenzylidene)dipalladium(0) (36 mg, 0.040 mmol, 2 mol %), tri-*tert*-butylphosphonium tetrafluoroborate (46 mg, 0.160 mmol, 8 mol %) and THF (30 mL) under a nitrogen atmosphere. A 2M K₂CO₃ solution (3 mL, 6.0 mmol) is added to the reaction mixture. The reaction mixture is heated to reflux and stirred for 48 h. Chlorobenzene is added and the reaction mixture precipitated from methanol. The polymer is filtered off, washed with methanol, and dried under vacuum. The polymer is washed via Soxhlet extraction with acetone, petrol 40-60 and methanol before drying under vacuum. The polymer is dissolved in hot chlorobenzene and re-precipitated from methanol. The polymer is filtered off, washed with methanol, and dried under vacuum to yield the product as an orange solid (0.61 g, 53%): Mₙ = 41,400 g mol⁻¹; M_{w} = 216,000 g mol⁻¹ (PhCl at 60°C).

### Example 2

The following polymer, poly(2,5-bis(3-dodecylthiophen-2-yl)thieno[2,3-b]thiophene), is prepared:

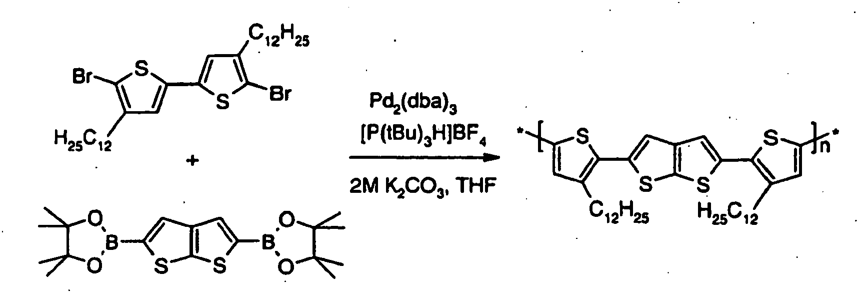

A 3-necked RBF is charged with 5,5'-dibromo-4,4'didodecylthiophene (0.661 g, 1.000 mmol), 2,5-bis(4,4,5,5-tetramethyl-1,3,2-dioxaborolan-2-yl)thieno[2,3-b]thiophene (0.392 g, 1.000 mmol), tris(dibenzylidene)dipalladium(0) (18 mg, 0.020 mmol, 2 mol %), tri-*tert*-butylphosphonium tetrafluoroborate (23 mg, 0.080 mmol, 8 mol %) and THF (25 mL) under a nitrogen atmosphere. A 2M K₂CO₃ solution (1.5 mL, 3.0 mmol) is added to the reaction mixture. The reaction mixture is heated to reflux and stirred for 24 h. Chlorobenzene is added and the reaction mixture precipitated from methanol. The polymer is filtered off, washed with methanol, and dried under vacuum. The polymer is washed via Soxhlet extraction with acetone, petrol 40-60 and methanol before drying under vacuum. The polymer is dissolved in hot chlorobenzene and re-precipitated from methanol. The polymer is filtered off, washed with methanol, and dried under vacuum to yield the product as an orange solid (0.49 g, 76%): Mₙ = 28,400 g mol⁻¹; M_{w} = 120,900 g mol⁻¹ (PhCl at 60°C).

### Example 3

The following polymer, poly(2,5-bis(3-decylthiophen-2-yl)thieno[2,3-b]thiophene), is prepared:

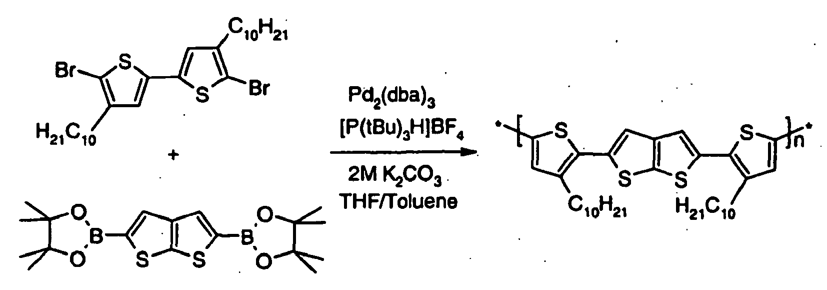

A 3-necked RBF is charged with 5,5'-dibromo-4,4'didecylthiophene (0.605 g, 1.000 mmol), 2,5-bis(4,4,5,5-tetramethyl-1,3,2-dioxaborolan-2-yl)thieno[2,3-*b*]thiophene (0.391 g, 1.000 mmol), tris(dibenzylidene)dipalladium(0) (18 mg, 0.020 mmol, 2 mol %), tri-*tert*-butylphosphonium tetrafluoroborate (23 mg, 0.080 mmol, 8 mol %) and THF (15 mL) under a nitrogen atmosphere. A 2M K₂CO₃ solution (1.5 mL, 3.0 mmol) is added to the reaction mixture. The reaction mixture is heated to reflux. After 30 minutes, toluene (15 mL) is added and the reaction mixture is stirred for a further 24 h. The reaction mixture precipitated from methanol. The polymer is filtered off, washed with methanol, and dried under vacuum. The polymer is washed via Soxhlet extraction with acetone and then dried under vacuum. The polymer is dissolved in hot chlorobenzene and re-precipitated from methanol. The polymer is filtered off, washed with methanol, and dried under vacuum to yield the product as an orange solid (0.54 g, 93%): Mₙ = 30,200 g mol⁻¹; M_{w} = 63,000 g mol⁻¹ (PhCl at 60°C).

### Example 4

The following polymer, poly(2,5-bis(3-decylthiophen-2-yl)thiophene), is prepared:

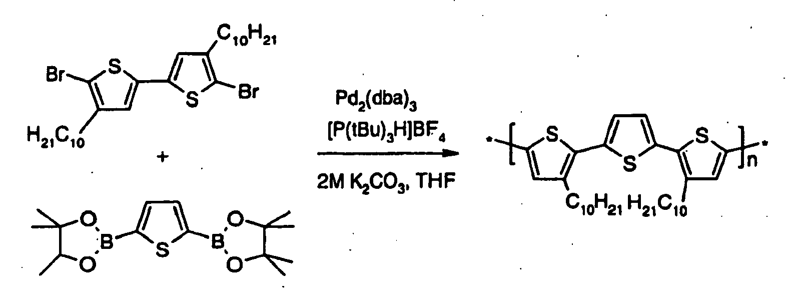

A 3-necked RBF is charged with 5,5'-dibromo-4,4'didecylthiophene (0.273 g, 0.452 mmol), 2,5-bis(4,4,5,5-tetramethyl-1,3,2-dioxaborolan-2-yl)thiophene (0.152 g, 0.452 mmol), tris(dibenzylidene)dipalladium(0) (8 mg, 0.009 mmol, 2 mol %), tri-*tert*-butylphosphonium tetrafluoroborate (10 mg, 0.036 mmol, 8 mol %) and THF (15 mL) under a nitrogen atmosphere. A 2M K₂CO₃ solution (0.7 mL, 1.4 mmol) is added to the reaction mixture. The reaction mixture is heated to reflux and stirred for 24 h. Chlorobenzene is added and the reaction mixture is precipitated from methanol. The polymer is filtered off, washed with methanol, and dried under vacuum. The polymer is washed via Soxhlet extraction with acetone, petrol 40-60 and methanol before drying under vacuum. The polymer is dissolved in hot chlorobenzene and re-precipitated from methanol. The polymer is filtered off, washed with methanol, and dried under vacuum to yield the product as a purple solid (0.12 g, 52%): Mₙ = 36,500 g mol⁻¹; M_{w} = 271,000 g mol⁻¹ (PhCl at 60°C).

### Example 5

The following polymer, poly(2,5-bis(3-dodecylthiophen-2-yl)thieno[3,2-b]thiophene), is prepared:

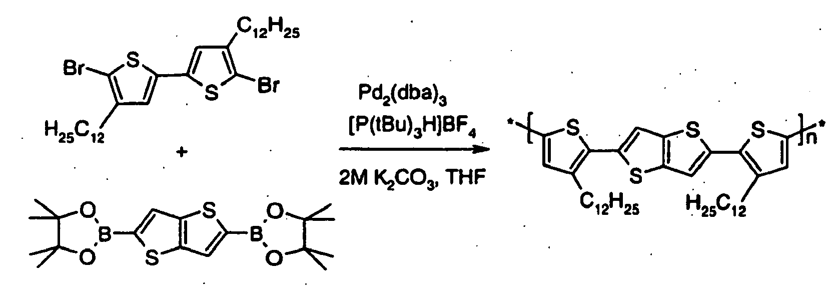

A 3-necked RBF is charged with 5,5'-dibromo-4,4'didodecylthiophene (0.661 g, 1.000 mmol), 2,5-bis(4,4,5,5-tetramethyl-1,3,2-dioxaborolan-2-yl)thieno[3,2-*b*]thiophene (0.392 g, 1.000 mmol), tris(dibenzylidene)dipalladium(0) (18 mg, 0.020 mmol, 2 mol %), tri-*tert*-butylphosphonium tetrafluoroborate (23 mg, 0.080 mmol, 8 mol %) and THF (15 mL) under a nitrogen atmosphere. A 2M K₂CO₃ solution (1.5 mL, 3.0 mmol) is added to the reaction mixture. The reaction mixture is heated to reflux and stirred for 24 h. Chlorobenzene is added and the reaction mixture precipitated from methanol. The polymer is filtered off, washed with methanol, and dried under vacuum. The polymer is washed via Soxhlet extraction with acetone ad then dried under vacuum. The polymer is dissolved in hot chlorobenzene and re-precipitated from methanol. The polymer is filtered off, washed with methanol, and dried under vacuum to yield the product as a purple solid (0.52 g, 81%): Mₙ = 29,400 g mol⁻¹; M_{w} = 48,100 g mol⁻¹ (PhCl at 60°C).

### Example 6

The following polymer, poly(3-hexylthiophene), is prepared:

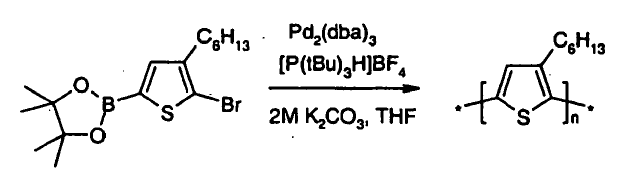

A 3-necked RBF is charged with 2-bromo-5-(4,4,5,5-tetramethyl-1,3,2-dioxaborolan-2-yl)-3-hexylthiophene (1.040 g, 2.731 mmol), tris(dibenzylidene)dipalladium(0) (26 mg, 0.028 mmol, 1 mol %), tri-*tert*-butylphosphonium tetrafluoroborate (32 mg, 0.110 mmol, 4 mol %) and THF (20 mL) under a nitrogen atmosphere. A 2M K₂CO₃ solution (5.6 mL, 11.2 mmol) is added to the reaction mixture. The reaction mixture is heated to reflux and stirred for 18 h. The reaction mixture is precipitated from methanol. The polymer is filtered off, washed with methanol, and dried under vacuum. The polymer is washed via Soxhlet extraction with iso-hexane and then dried under vacuum. The polymer is dissolved in hot chloroform and re-precipitated from methanol. The polymer is filtered off, washed with methanol, and dried under vacuum to yield the product as a purple sold (0.30 g, 64%) with 94% head-to-tail (HT) regioregularity according to ¹H-NMR. The regioregularity is determined by intergration of the methylene protons around 2.8 ppm (see T.A. Chen, X. Wu, R.D. Rieke J. Am. Chem. Soc., 1995, 117, p233): ¹H-NMR (300 MHz, CDCl₃) δ 6.98 (s, 1 H), 2.80 (t, 2H, ³J = 7.5 Hz), 1.71 (m, 2H), 1.36 (m, 6H), 0.91 (t, 3H, ³J = 7 Hz); Mₙ= 25,000 g mol⁻¹; M_{w} = 56,000 g mol⁻¹ (PhCl at 60°C).

### Example 7

The following polymer, poly(2,5-bis(3-decylthiophen-2-yl)thieno[2,3-b]thiophene), is prepared:

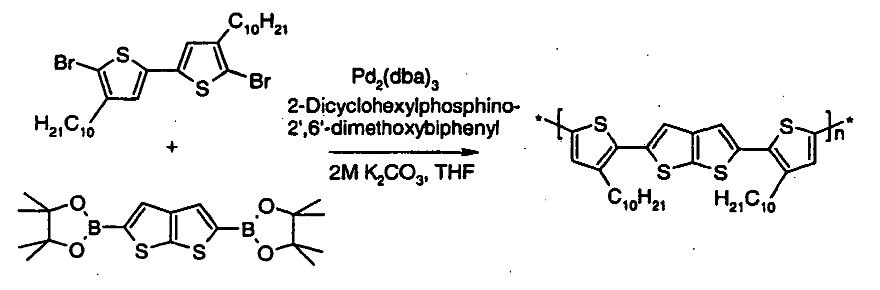

A 3-necked RBF is charged with 5,5'-dibromo-4,4'didecylthiophene (0.605 g, 1.000 mmol), 2,5-bis(4,4,5,5-tetramethyl-1,3,2-dioxaborolan-2-yl)thieno[2,3-b]thiophene (0.392 g, 1.000 mmol), tris(dibenzylidene)dipalladium(0) (18 mg, 0.020 mmol, 2 mol %), 2-dicyclohexylphosphino-2',6'-dimethoxybiphenyl (33 mg, 0.080 mmol, 8 mol %) and THF (15 mL) under a nitrogen atmosphere. A 2M K₂CO₃ solution (1.5 mL, 3.0 mmol) is added to the reaction mixture. The reaction mixture is heated to reflux and stirred for 24 h. The reaction mixture is precipitated from methanol. The polymer is filtered off, washed with methanol, water, and then methanol again, and dried under vacuum to yield the product as an orange solid (0.55 g, 94%): Mₙ = 11,100 g mol⁻¹; M_{w} = 30,300 g mol⁻¹ (PhCl at 60°C).

### Example 8

The following polymer, poly(3-hexylthiophene), is prepared:

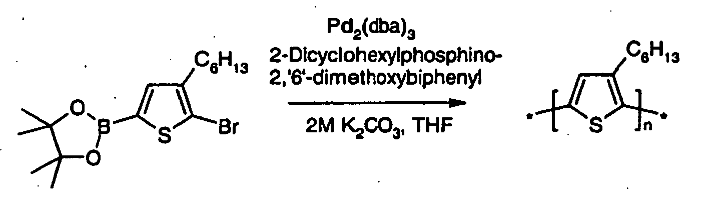

Into a flame-dried Schlenk flask is placed anhydrous K₃PO₄ (3.4 g, 16.1 mmol), Pd(OAc)₂ (0.024 g, 0.107 mmol), 2-bromo-5-(4,4,5,5-tetramethyl-1,3,2-dioxaborolan-2-yl)-3-hexylthiophene (2.00 g, 5.36 mmol) and 2-dicyclohexylphosphino-2',6'-dimethoxybiphenyl (0.044 g, 0.107 mmol) under Ar. Anhydrous THF (50 mL) is added and the reaction is stirred at room temperature for 16 h. It is then brought to reflux for a further 3 hours, allowed to cool to room temperature, and poured into MeOH (200 mL). The precipitate formed is filtered through a Soxhlet thimble, and worked up as described above. The precipitate is Soxhlet-extracted with, successively, MeOH, acetone, hexane, CH₂Cl₂ and THF. The hexane, CH₂Cl₂ and THF fractions are separately evaporated to small volume and precipitated into MeOH, filtered and dried in *vacuo.* Yield: CH₂Cl₂: 0.174 g, (19.5%); THF: 0.173 g, (19.4 %). CH₂Cl₂ fraction: 93.6% HT regioregularity, GPC (in THF at 40°C) *M*_{W} = 11400, *M*ₙ = 10000, PD = 1.14. THF fraction: 97% HT regioregularity. GPC (in THF at 40°C) *M*_{W} = 16900, *M*ₙ = 15200, PD = 1.105.

### Example 9

The following polymer, poly(3,6-didodecylthieno[3,2-b]thiophene-*alt-*2,5-thiophene), is prepared:

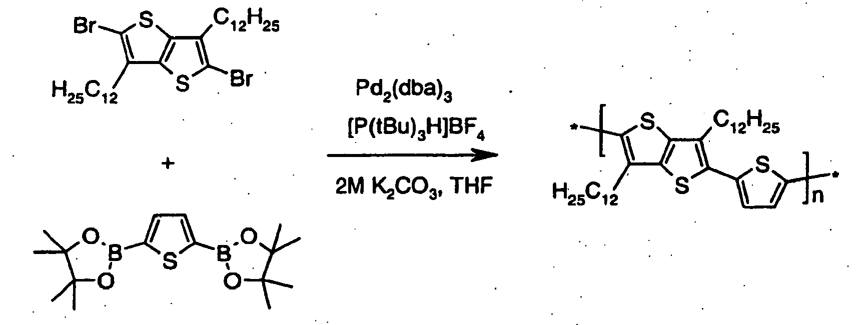

A 3-necked RBF is charged with 2,5-dibromo-3,6-didodecylthieno[3,2-*b*]thiophene (0.166 g, 0.261 mmol), 2,5-bis(4,4,5,5-tetramethyl-1,3,2-dioxaborolan-2-yl)thiophene (0.088 g, 0.261 mmol), tris(dibenzylidene)dipalladium(0) (5 mg, 0.005 mmol, 2 mol %), tri-*tert-*butylphosphonium tetrafluoroborate (6 mg, 0.021 mmol, 8 mol %) and THF (10 mL) under a nitrogen atmosphere. A 2M K₂CO₃ solution (0.8 mL, 1.6 mmol) is added to the reaction mixture. The reaction mixture is heated to reflux and stirred for 24 h. Chlorobenzene is added and the reaction mixture precipitated from methanol. The polymer is filtered off, washed with methanol, and dried under vacuum. The polymer is washed via Soxhlet extraction with acetone and then dried under vacuum. The polymer is dissolved in hot chlorobenzene and re-precipitated from methanol. The polymer is filtered off, washed with methanol, and dried under vacuum to yield the product as a dark red solid (0.10 g, 68%): Mₙ = 6,800 g mol⁻¹; M_{w} = 15,600 g mol⁻¹ (PhCl at 60°C).

### Example 10

The following polymer, poly(3,6-dihexadecylthieno[3,2-b]thiophene-*alt*-5,5'-bithiophene), is prepared:

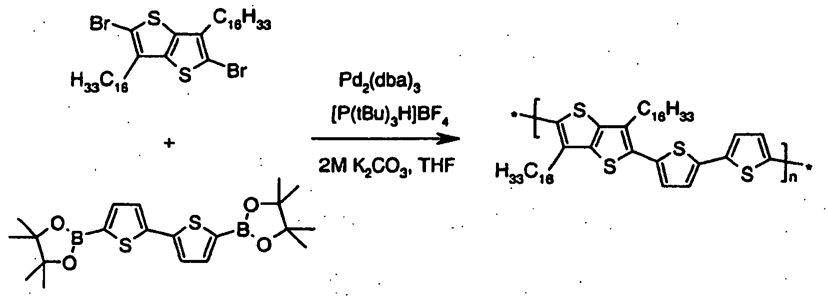

A 3-necked RBF is charged with 2,5-dibromo-3,6-dihexadecylthieno[3,2-b]thiophene (0.373 g, 0.500 mmol), 5,5'-bis(4,4,5,5-tetramethyl-1,3,2-dioxaborolan-2-yl)bithiophene (0.209 g, 0.500 mmol), tris(dibenzylidene)dipalladium(0) (9 mg, 0.010 mmol, 2 mol %), tri-*tert*-butylphosphonium tetrafluoroborate (12 mg, 0.040 mmol, 8 mol %) and THF (20 mL) under a nitrogen atmosphere. A 2M K₂CO₃ solution (0.75 mL, 1.5 mmol) is added to the reaction mixture. The reaction mixture is heated to reflux and stirred for 24 h. Chlorobenzene is added and the reaction mixture precipitated from methanol. The polymer is filtered off, washed with methanol, and dried under vacuum. The polymer is washed via Soxhlet extraction with acetone and then dried under vacuum. The polymer is dissolved in hot chlorobenzene and re-precipitated from methanol. The polymer is filtered off, washed with methanol, and dried under vacuum to yield the product as a dark red solid (0.275 g, 73%): Mₙ = 8,000 g mol⁻¹; M_{w} = 17,500 g mol⁻¹ (PhCl at 60°C).

## Claims

1. Process for polymerising a heteroaromatic compound under formation of aryl-aryl C-C couplings, wherein said compound has at least one functional halide group and at least one functional boron group, or copolymerizing at least one first and at least one second heteroaromatic compound under formation of aryl-aryl C-C couplings, wherein said first compound has at least two functional halide groups and said second compound has at least two functional boron groups, wherein the polymerisation is carried out in presence of
a) a catalyst/ligand system comprising a palladium catalyst and an organic phosphine or phosphonium compound,
b) a base,
c) a solvent or a mixture of solvents,
**characterized in that**
the functional halide and boron groups are attached to a thiophene or selenophene ring that is optionally substituted and optionally fused to another ring, and
the organic phosphine or phosphonium compound is a trisubstituted phosphine or phosphonium salt with substituents selected from optionally substituted alkyl and aryl groups, and the organic phosphine compound is formed in situ from the corresponding phosphonium salt during the process by the addition of the base.

2. Process according to claim 1, **characterized in that** the halide group is selected from halogen or -OSO₂R^{x} wherein R^{x} is optionally fluorinated alkyl or aryl having 1 to 12 C atoms.

3. Process according to claim 2, **characterized in that** the halide group is selected from Br, I, mesylate, triflate or tosylate.

4. Process according to at least one of the preceding claims, **characterized in that** the boron group is selected from a boronic acid, boronic acid ester (boronate) or borane group.

5. Process according to claim 4, **characterized in that** the boron group is of the formula -B(OR')(OR") or BR'R", wherein R' and R" are independently of each other H or alkyl with 1 to 12 C-atoms, or R' and R" together form an alkylene or arylene group having 2 to 20 C atoms.

6. Process according to claim 5, **characterized in that** the boron group is selected of the following formulae

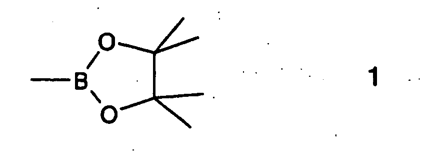

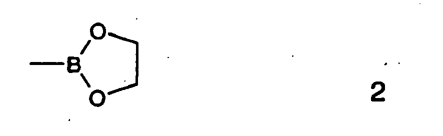

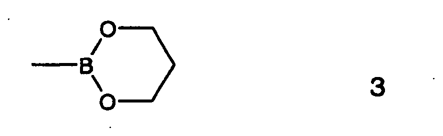

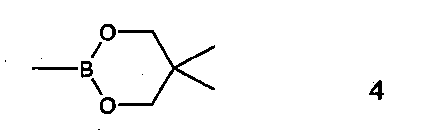

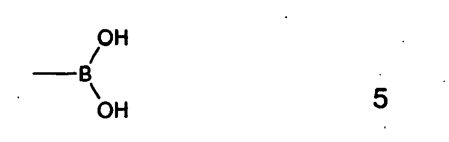

7. Process according to at least one of the preceding claims, **characterized in that** the heteroaromatic compounds are selected of formula I
X¹-(Ar¹)ₐ-(Ar²)_{b}-(Ar³)_{c}-X² I
wherein
Ar¹ and Ar³ are, in case of multiple occurrence independently of one another, identical or different arylene or heteroarylene groups, which are optionally substituted with one or more groups R, optionally comprise fused rings, and comprise a thiophene ring or a selenophene ring linked to X¹ and/or X², respectively,
Ar² is, in case of multiple occurrence independently of one another, an arylene or heteroarylene group that is optionally substituted with one or more groups R and optionally comprises fused rings,
a and c are independently of each other 1, 2 or 3, and, in case b is 0, one of a and c may also be 0,
b is 0, 1, 2, 3 or 4,
X¹ and X² are independently of each other a functional halide group or a functional boron group,
R in case of multiple occurrence independently of one another has one of the meanings of X¹ or is aryl, heteroaryl, aryloxy or heteroaryloxy, which is optionally substituted by one or more groups L, or straight chain, branched or cyclic alkyl with 1 to 20 C-atoms, which is optionally mono- or polysubstituted by F, Cl, Br or I, and wherein one or more non-adjacent CH₂ groups are optionally replaced, in each case independently from one another, by -O-, -S-, -NR⁰-, -SiR⁰R⁰⁰-, -CY¹=CY²- or - C=C- in such a manner that O and/or S atoms are not linked directly to one another, or is selcted from F, Cl, CN, NO₂, NR⁰R⁰⁰, -SiR⁰R⁰⁰R⁰⁰⁰, -C≡C- SiR⁰R⁰⁰R⁰⁰⁰ or sulfonyl, or is H
L is F, Cl, Br, I, CN, NO₂, NR⁰R⁰⁰, -SiR⁰R⁰⁰R⁰⁰⁰, - C≡C-SiR⁰R⁰⁰R⁰⁰⁰, sulfonyl, or straight chain, branched or cyclic alkyl having 1 to 20 C atoms, which is unsubstituted, mono- or poly-substituted by F, Cl, Br, I, -CN or -OH, and in which one or more non-adjacent CH₂ groups are optionally replaced, in each case independently from one another, by -O-, -S-, -NH-, -NR⁰-, -SiR⁰R⁰⁰- -CO-, - COO-, OCO-, -OCO-O, -S-CO-, -CO-S-,-CH=CH- or -C≡C- in such a manner that O and/or S atoms are not linked directly to one another,
Y¹ and Y² are independently of each other H, F or Cl,
R⁰, R⁰⁰ and R⁰⁰⁰ are independently of each other H, alkyl with 1 to 12 C-atoms or aryl.

8. Process according to claim 7, **characterized in that** Ar¹ and Ar³ are selected from thiophene-2,5-diyl, selenophene-2,5-diyl or thieno[2,3-b]thiophene-2,5-diyl which are optionally substituted in 3- and/or 4-position with R, thieno[3,2-b]thiophene-2,5-diyl which is optionally substituted in 3- and/or 6-position with R, or benzo[1,2-b:4,5-b'] dithiophene-2,6-diyl which is optionally substituted in 3-, 4- 7- or 8-position with R.

9. Process according to at least one of the preceding claims, **characterized in that** the heteroaromatic compounds are selected of the following formulae 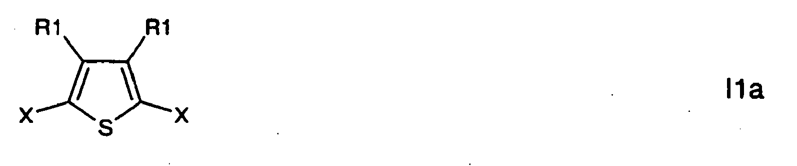 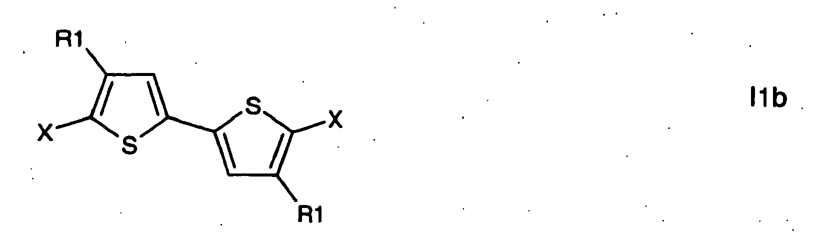 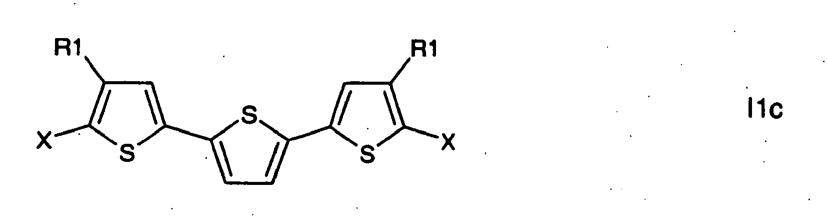 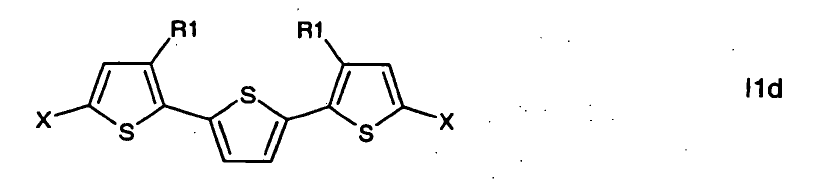 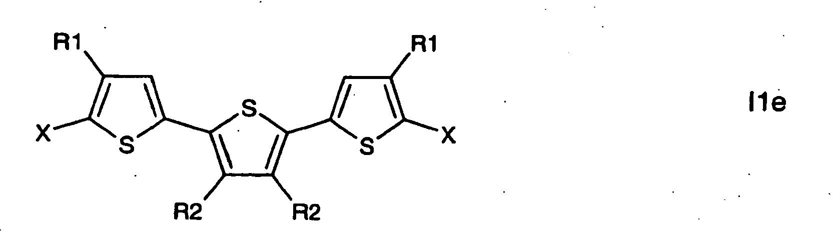 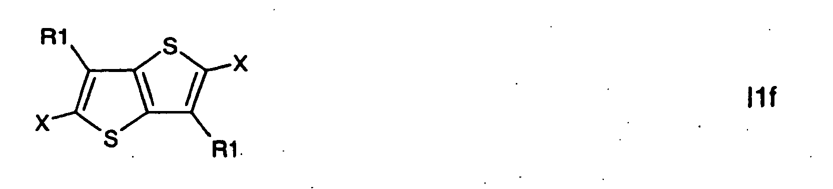 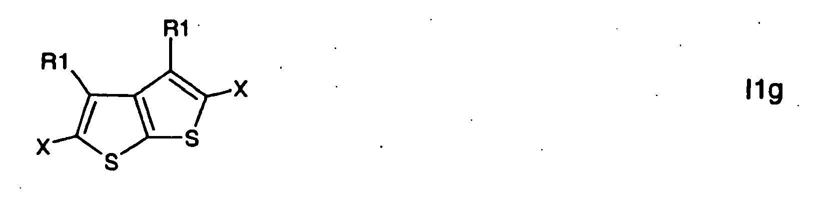 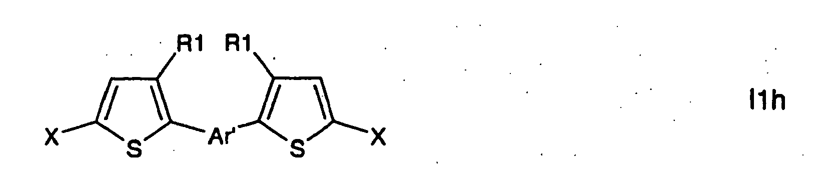 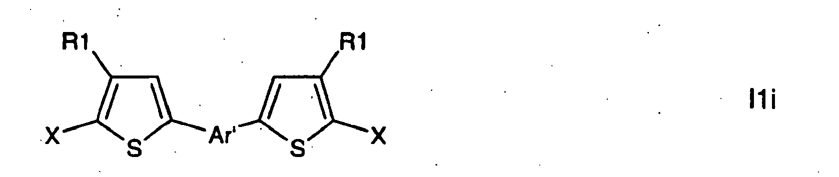 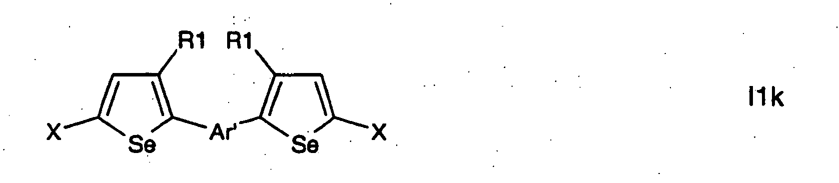 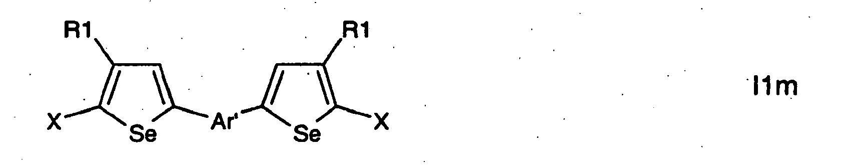 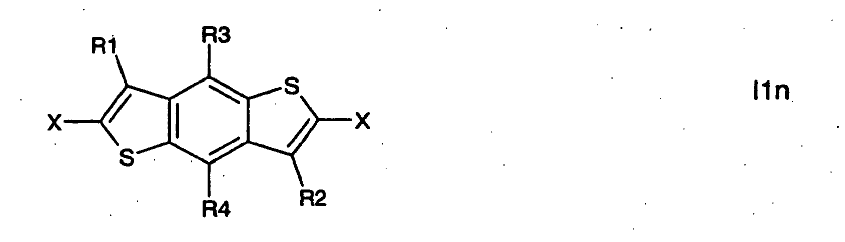 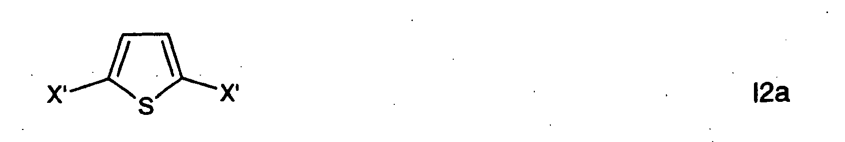 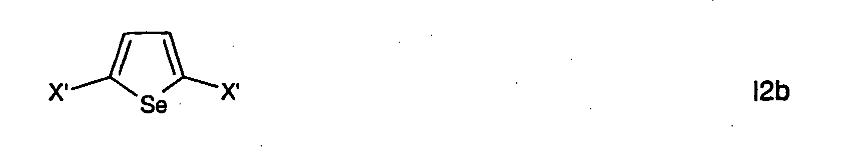 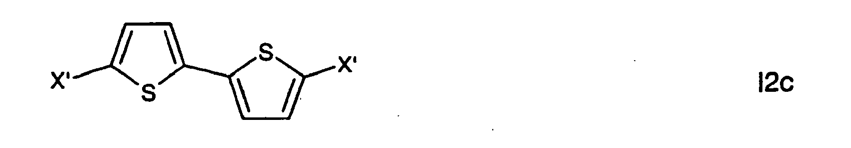 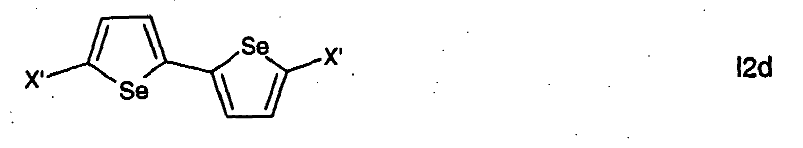 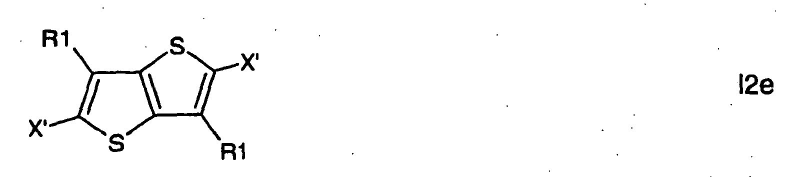 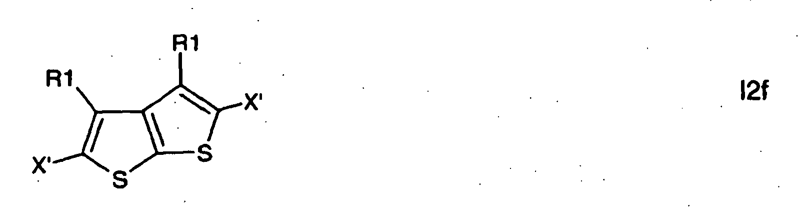 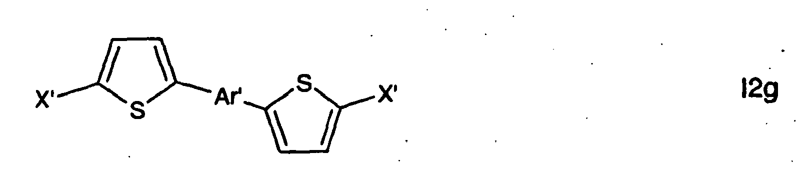 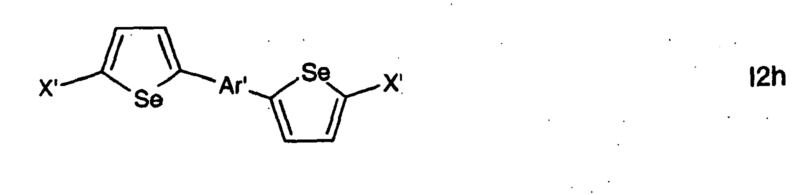 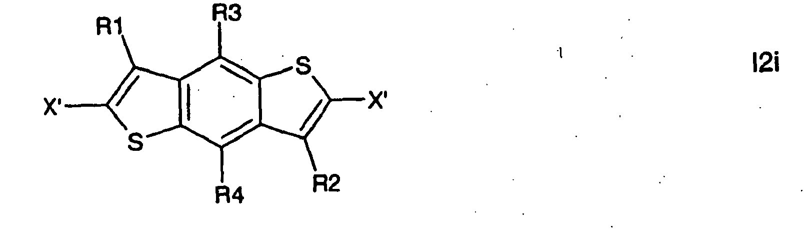 wherein
Ar' has one of the meanings for Ar² given in the preceding claims,
X is a halide group as defined in the preceding claims,
X' is a boron group as defined in the preceding claims, and
R¹⁻⁴ have independently of each other one of the meanings of R in formula I.

10. Process according to at least one of the preceding claims, **characterized in that** the palladium catalyst is selected from Pd(II) halides, PD(II) carboxylates, Pd(II)p-diketonates, Pd₂(dba)₃, Pd(dba)₂, Pd(PR'₃)₂, Pd(OAc)₂, PdCl₂(PR'₃)₂, PdCl₂(PhCN)₂, PdCl₂(CH₃CN) or PdCl₂(cod), wherein R' is alkyl or aryl.

11. Process according to one or more of the preceding claims, **characterized in that** the palladium catalyst is a phosphine-free palladium (II) catalyst.

12. Process according to at least one of the preceding claims, **characterized in that** the trisubstituted phosphine is of the formula R^{a}ₓR^{b}_{y}R^{c}_{z}P, wherein
P denotes phosphorus,
R^{a}, R^{b} and R^{c} are identical or different straight-chain, branched or cyclic alkyl groups with 1 to 12 C atoms that are optionally fluorinated or aryl groups with 4 to 20 C atoms that are optionally substituted,
x, y and z are 0, 1, 2 or 3, with x+y+z = 3.

13. Process according to claim 12, **characterized in that** the trisubstituted phosphine is of the formula R^{a}₃P wherein all groups R^{a} are identical, or of the formulae R^{a}₂R^{b}P or R^{a}R^{b}₂P, wherein R^{a} and R^{b} are different.

14. Process according to claim 12 or 13, **characterized in that** R^{a} and R^{b} are alkyl as defined in claim 12, or R^{a} is an alkyl group and R^{b} is an aryl group as defined in claim 12.

15. Process according to at least one of claims 12 to 14, **characterized in that** the trisubstituted phosphine is selected from triethylphosphine, tri-iso-propyl-phosphine, tricyclohexylphosphine, tri-tert-butylphosphine (t-Bu), bis(di-tert-butylphosphino)methane and 2-dicyclohexylphosphino-2',6'-dimethoxybiphenyl.

16. Process according to at least one of claims 12 to 15, **characterized in that** the trisubstituted phosphonium salt is selected from the formula [R^{a}ₓR^{b}_{y}R^{c}_{z}PH]⁺Z⁻, wherein R^{a-c} and x, y and z are as defined in claim 12 and Z⁻ is a suitable anion.

17. Process according to claim 16, **characterized in that** Z⁻ is BF₄⁻, PF₆⁻ or SbF₆⁻.

18. Process according to claim 16 or 17, **characterized in that** the trisubstituted phosphonium salt is [t-Bu₃PH] BF₄.

19. Process according to at least one of the preceding claims, **characterized in that** the base is selected from alkali metal or alkaline earth metal hydroxides, carboxylates, carbonates, fluorides and phosphates.

20. Process according to claim 19, **characterized in that** the base is aqueous K₂CO₃ or Na₂CO₃.

21. Process according to at least one of the preceding claims, **characterized in that** at least 1.5 equivalents of said base per functional boron group is present in the reaction mixture.

22. Process according to at least one of the preceding claims, **characterized in that** the solvent is selected from toluene, xylene, anisole, THF, 2-methyltetrahydrofuran, dioxane, chlorobenzene, fluorobenzene or a mixture of one or more of these solvents.

## Patentansprüche

1. Verfahren zur Polymerisierung einer heteroaromatischen Verbindung unter Bildung von Aryl-Aryl-C-C-Kupplungen, wobei die Verbindung mindestens eine funktionelle Halogenidgruppe und mindestens eine funktionelle Borgruppe aufweist, oder Copolymerisierung mindestens einer ersten und mindestens einer zweiten heteroaromatischen Verbindung unter Bildung von Aryl-Aryl-C-C-Kupplungen, wobei die erste Verbindung mindestens zwei funktionelle Halogenidgruppen und die zweite Verbindung mindestens zwei funktionelle Borgruppen aufweist, wobei die Polymerisation in Gegenwart
a) eines Katalysator/Ligand-Systems, das einen Palladiumkatalysator und eine organische Phosphin- oder Phosphoniumverbindung enthält,
b) einer Base,
c) eines Lösungsmittels oder eines Lösungsmittelgemisches, durchgeführt wird, **dadurch gekennzeichnet, dass**
die funktionellen Halogenid- und Borgruppen an einen Thiophen- oder Selenophenring gebunden sind, der gegebenenfalls substituiert und gegebenenfalls mit einem anderen Ring anelliert ist, und
es sich bei der organischen Phosphin- oder Phosphoniumverbindung um ein trisubstituiertes Phosphin- oder Phosphoniumsalz handelt, bei dem die Substituenten aus gegebenenfalls substituierten Alkyl- und Arylgruppen ausgewählt sind, und
die organische Phosphinverbindung in situ aus dem entsprechenden Phosphoniumsalz während des Verfahrens durch die Zugabe der Base gebildet wird.

2. Verfahren nach Anspruch 1, **dadurch gekennzeichnet, dass** die Halogenidgruppe aus Halogen oder -OSO₂R^{x}, wobei R^{x} gegebenenfalls fluoriertes Alkyl oder Aryl mit 1 bis 12 C-Atomen bedeutet, ausgewählt ist.

3. Verfahren nach Anspruch 2, **dadurch gekennzeichnet, dass** die Halogenidgruppe aus Br, I, Mesylat, Triflat oder Tosylat ausgewählt ist.

4. Verfahren nach mindestens einem der vorhergehenden Ansprüche, **dadurch gekennzeichnet, dass** die Borgruppe aus einer Borsäure, einem Borsäureester (Boronat) oder einer Borangruppe ausgewählt ist.

5. Verfahren nach Anspruch 4, **dadurch gekennzeichnet, dass** die Borgruppe die Formel -B(OR')(OR") oder BR'R" besitzt, worin R' und R" unabhängig voneinander H oder Alkyl mit 1 bis 12 C-Atome bedeuten oder R' und R" zusammen eine Alkylen- oder Arylengruppe mit 2 bis 20 C-Atomen bilden.

6. Verfahren nach Anspruch 5, **dadurch gekennzeichnet, dass** die Borgruppe aus den folgenden Formeln ausgewählt ist:

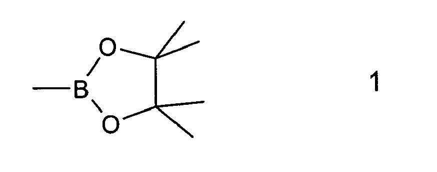

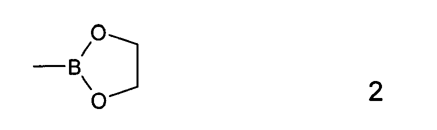

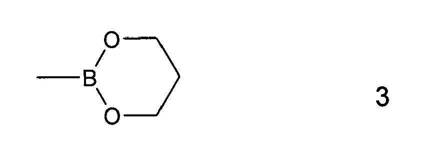

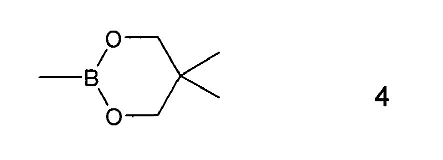

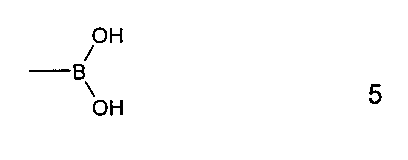

7. Verfahren nach mindestens einem der vorhergehenden Ansprüche, **dadurch gekennzeichnet, dass** die heteroaromatischen Verbindungen aus der Formel I
X¹-(Ar¹)ₐ-(Ar²)_{b}-(Ar³)_{c}-X² I
ausgewählt sind, worin
Ar¹ und Ar³, bei mehrfachem Auftreten unabhängig voneinan- der, gleiche oder verschiedene Arylen- oder Hetero- arylengruppen bedeuten, die gegebenenfalls mit einer oder mehreren Gruppen R substituiert sind, gegebenenfalls anellierte Ringe enthalten und einen Thiophenring oder einen Selenophenring enthalten, der mit X¹ bzw. X² verknüpft ist,
Ar², bei mehrfachem Auftreten unabhängig voneinan- der, eine Arylen- oder Heteroarylengruppe bedeu- tet, die gegebenenfalls mit einer oder mehreren Gruppen R substituiert ist und gegebenenfalls anellierte Ringe enthält,
a und c unabhängig voneinander für 1, 2 oder 3 stehen und, wenn b gleich 0, eines von a und c auch für 0 stehen kann,
b für 0, 1, 2, 3 oder 4 steht,
X¹ und X² unabhängig voneinander eine funktionelle Haloge- nidgruppe oder eine funktionelle Borgruppe bedeuten,
R bei mehrfachem Auftreten unabhängig voneinander eine der Bedeutungen von X¹ aufweist oder Aryl, Heteroaryl, Aryloxy oder Heteroaryloxy, das gege- benenfalls durch eine oder mehrere Gruppen L substituiert ist, oder geradkettiges, verzweigtes oder cyclisches Alkyl mit 1 bis 20 C-Atomen, das gegebenenfalls ein- oder mehrfach durch F, Cl, Br oder I substituiert ist und in dem gegebenenfalls eine oder mehrere nicht benachbarte CH₂-Gruppen jeweils unabhängig voneinander so durch -O-, -S-, -NR⁰-, -SiR⁰R⁰⁰-, -CY¹=CY²- oder -C≡C- ersetzt sind, dass O- und/oder S-Atome nicht direkt mitein- ander verknüpft sind, bedeutet oder aus F, Cl, CN, NO₂, NR⁰R⁰⁰, -SiR⁰R⁰⁰R⁰⁰⁰, -C≡C-SiR⁰R⁰⁰R⁰⁰⁰ oder Sulfonyl ausgewählt ist oder H bedeutet,
L F, Cl, Br, I, CN, NO₂, NR⁰R⁰⁰, -SiR⁰R⁰⁰R⁰⁰, -C≡C- SiR⁰R⁰⁰R⁰⁰⁰, Sulfonyl oder geradkettiges, verzweig- tes oder cyclisches Alkyl mit 1 bis 20 C-Atomen bedeutet, das unsubstituiert oder ein- oder mehr- fach durch F, Cl, Br, I, -CN oder -OH substituiert ist und in dem gegebenenfalls eine oder mehrere nicht benachbarte CH₂-Gruppen jeweils unabhängig von- einander so durch -O-, -S-, -NH-, -NR⁰-, -SiR⁰R⁰⁰-, -CO-, -COO-, -OCO-, -OCO-O, -S-CO-, -CO-S-, -CH=CH- oder -C≡C- ersetzt sind, dass O- und/ oder S-Atome nicht direkt miteinander verknüpft sind,
Y¹ und Y² unabhängig voneinander H, F oder Cl bedeuten,
R⁰, R⁰⁰ und R⁰⁰⁰ unabhängig voneinander H, Alkyl mit 1 bis 12 C-Atomen oder Aryl bedeuten.

8. Verfahren nach Anspruch 7, **dadurch gekennzeichnet, dass** Ar¹ und Ar³ aus Thiophen-2,5-diyl, Selenophen-2,5-diyl oder Thieno[2,3-b]thiophen-2,5-diyl, die gegebenenfalls in 3- und/oder 4-Position mit R substituiert sind, Thieno[3,2-b]thiophen-2,5-diyl, das gegebenenfalls in 3- und/oder 6-Position mit R substituiert ist, oder Benzo[1,2-b:4,5-b']dithiophen-2,6-diyl, das gegebenenfalls in 3-, 4-, 7- oder 8-Position mit R substituiert ist, ausgewählt sind.

9. Verfahren nach mindestens einem der vorhergehenden Ansprüche, **dadurch gekennzeichnet, dass** die heteroaromatischen Verbindungen aus den folgenden Formeln ausgewählt sind: 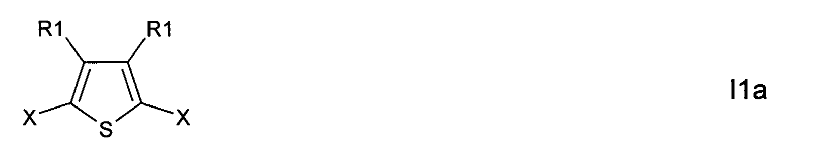 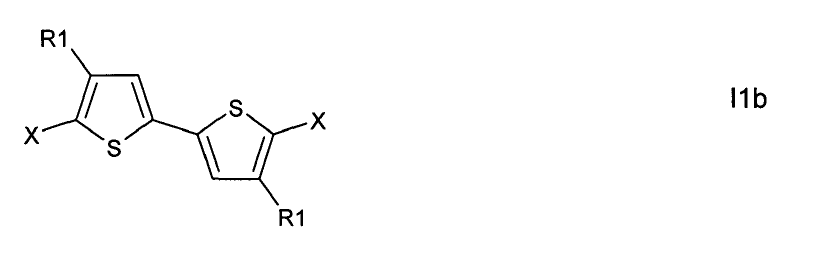 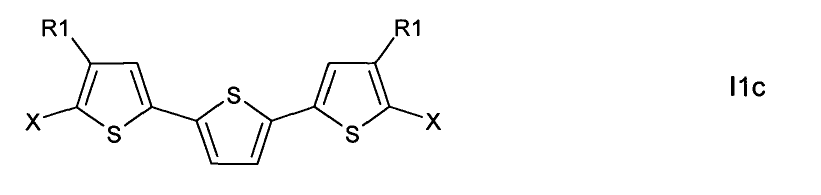 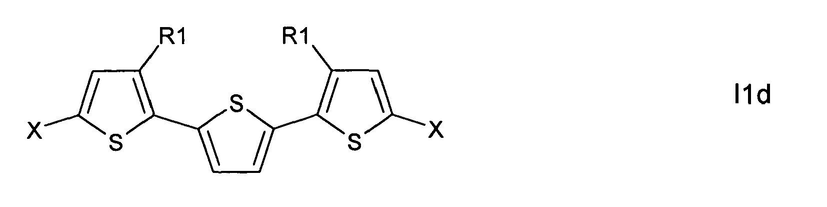 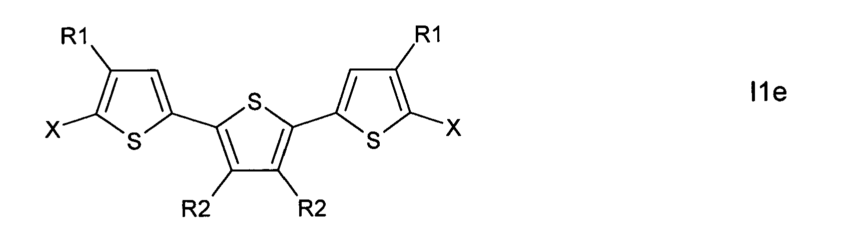 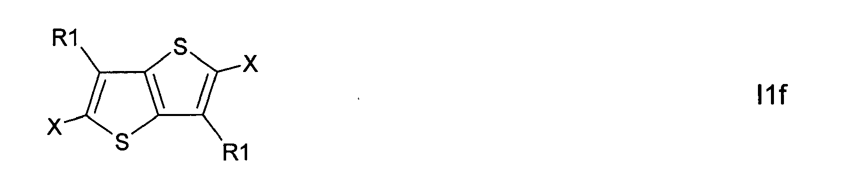 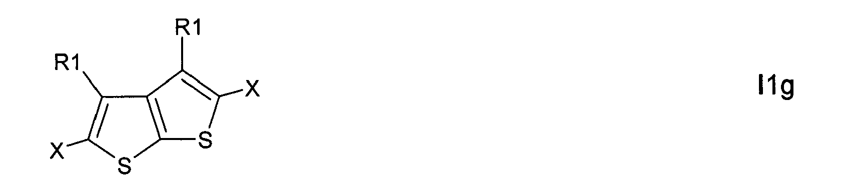 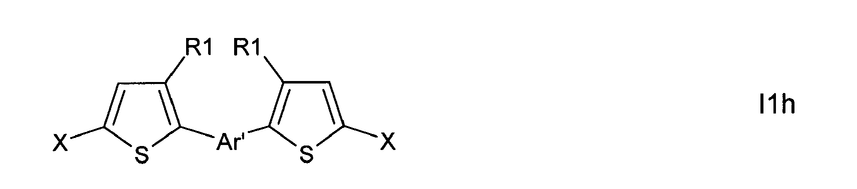 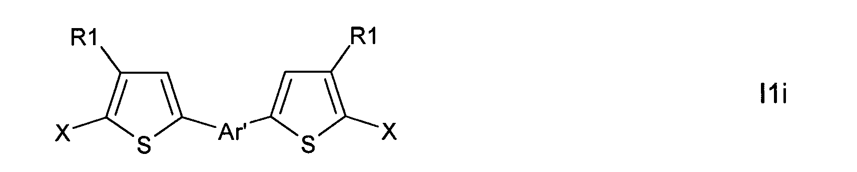 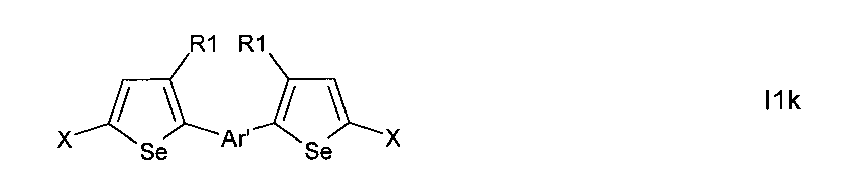 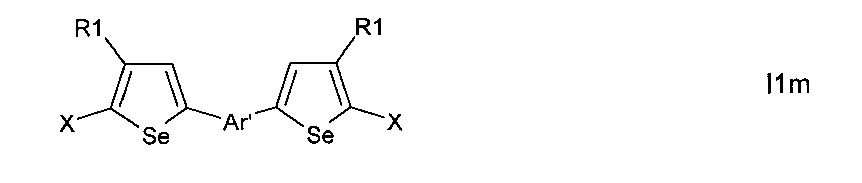 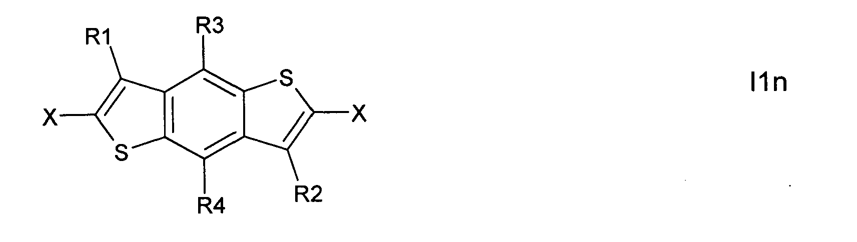 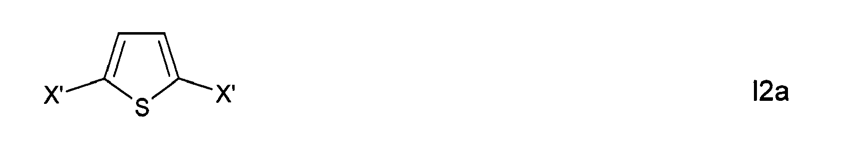 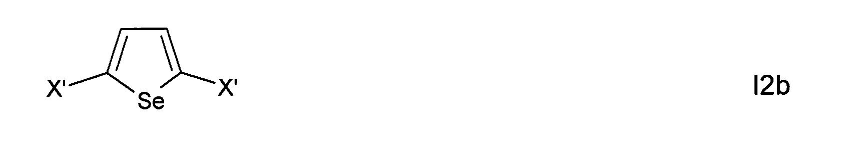 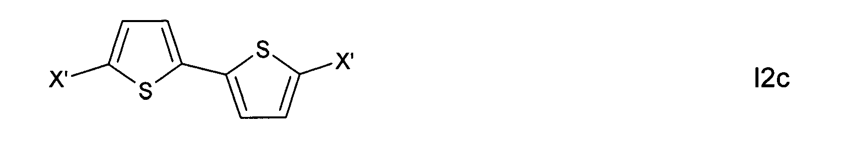 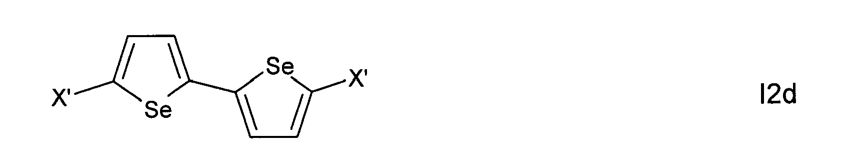 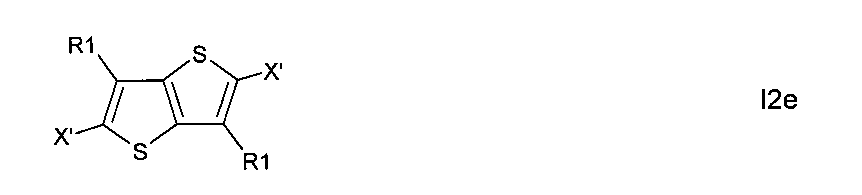 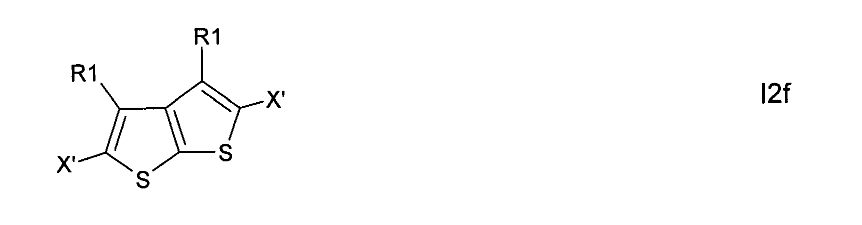 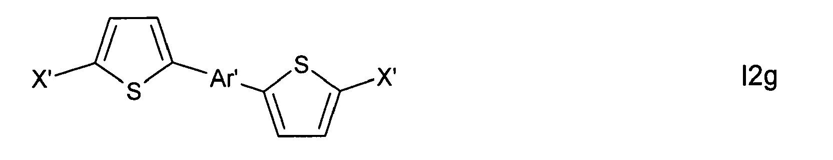 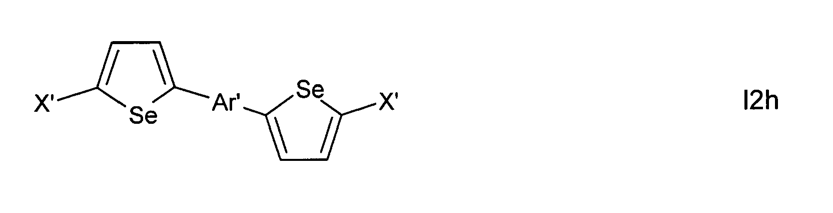 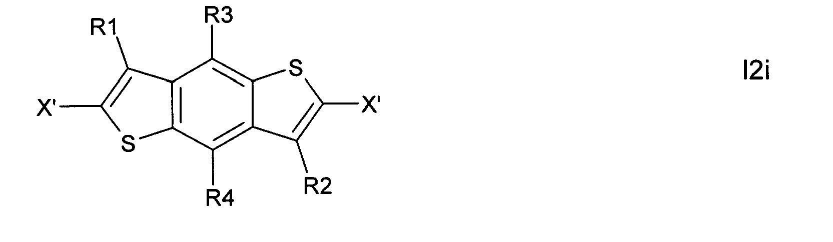 worin
Ar' eine der in den vorhergehenden Ansprüchen für Ar² angegebenen Bedeutungen besitzt,
X eine Halogenidgruppe wie in den vorhergehenden Ansprüchen definiert bedeutet,
X' eine Borgruppe wie in den vorhergehenden An- sprüchen definiert bedeutet und
R¹⁻⁴ unabhängig voneinander eine der Bedeutungen von R in Formel I besitzen.

10. Verfahren nach mindestens einem der vorhergehenden Ansprüche, **dadurch gekennzeichnet, dass** der Palladiumkatalysator aus Pd(II)-Halogeniden, Pd(II)-Carboxylaten, Pd(II)β-Diketonaten, Pd₂(dba)₃, Pd(dba)₂, Pd(PR'₃)₂, Pd(OAc)₂, PdCl₂(PR'₃)₂, PdCl₂(PhCN)₂, PdCl₂(CH₃CN) oder PdCl₂(cod) ausgewählt ist, worin R' Alkyl oder Aryl bedeutet.

11. Verfahren nach einem oder mehreren der vorhergehenden Ansprüche, **dadurch gekennzeichnet, dass** es sich bei dem Palladiumkatalysator um einen phosphinfreien Palladium(II)-Katalysator handelt.

12. Verfahren nach mindestens einem der vorhergehenden Ansprüche, **dadurch gekennzeichnet, dass** das trisubstituierte Phosphin die Formel R^{a}ₓR^{b}_{y}R^{c}_{z}P besitzt, worin
P Phosphor bedeutet,
R^{a}, R^{b} und R^{c} gleiche oder verschiedene geradkettige, verzweigte oder cyclische Alkylgruppen mit 1 bis 12 C-Atomen, die gegebenenfalls fluoriert sind, oder Arylgruppen mit 4 bis 20 C-Atomen, die gegebenenfalls substituiert sind, bedeuten,
x, y und z für 0, 1, 2 oder 3 stehen, wobei x+y+z = 3.

13. Verfahren nach Anspruch 12, **dadurch gekennzeichnet, dass** das trisubstituierte Phosphin die Formel R^{a}₃P, worin alle Gruppen R^{a} gleich sind, oder die Formeln R^{a}₂R^{b}P oder R^{a}R^{b}₂P, worin R^{a} und R^{b} verschieden sind, besitzt.

14. Verfahren nach Anspruch 12 oder 13, **dadurch gekennzeichnet, dass** R^{a} und R^{b} Alkyl wie in Anspruch 12 definiert bedeuten oder R^{a} eine Alkylgruppe und R^{b} eine Arylgruppe wie in Anspruch 12 definiert bedeutet.

15. Verfahren nach mindestens einem der Ansprüche 12 bis 14, **dadurch gekennzeichnet, dass** das trisubstituierte Phosphin aus Triethylphosphin, Tri-iso-propyl-phosphin, Tri-cyclohexylphosphin, Tri-tert-butylphosphin (t-Bu), Bis(di-tert-butylphosphino)-methan und 2-Dicyclohexylphosphino-2',6'-dimethoxybiphenyl ausgewählt ist.

16. Verfahren nach mindestens einem der Ansprüche 12 bis 15, **dadurch gekennzeichnet, dass** das trisubstituierte Phosphoniumsalz aus der Formel [R^{a}ₓR^{b}_{y}R^{c}_{z}PH]⁺Z⁻ ausgewählt ist, worin R^{a-c} und x, y und z wie in Anspruch 12 definiert sind und Z⁻ ein geeignetes Anion bedeutet.

17. Verfahren nach Anspruch 16, **dadurch gekennzeichnet, dass** Z⁻BF₄⁻, PF₆⁻ oder SbF₆⁻ bedeutet.

18. Verfahren nach Anspruch 16 oder 17, **dadurch gekennzeichnet, dass** es sich bei dem trisubstituierten Phosphoniumsalz um [t-Bu₃PH]BF₄ handelt.

19. Verfahren nach mindestens einem der vorhergehenden Ansprüche, **dadurch gekennzeichnet, dass** die Base aus Alkali- oder Erdalkalihydroxiden, -carboxylaten, -carbonaten, -fluoriden und -phosphaten ausgewählt ist.

20. Verfahren nach Anspruch 19, **dadurch gekennzeichnet, dass** es sich bei der Base um wässriges K₂CO₃ oder Na₂CO₃ handelt.

21. Verfahren nach mindestens einem der vorhergehenden Ansprüche, **dadurch gekennzeichnet, dass** pro funktioneller Borgruppe mindestens 1,5 Äquivalente der Base in der Reaktionsmischung vorliegen.

22. Verfahren nach mindestens einem der vorhergehenden Ansprüche, **dadurch gekennzeichnet, dass** das Lösungsmittel aus Toluol, Xylol, Anisol, THF, 2-Methyltetrahydrofuran, Dioxan, Chlorbenzol, Fluorbenzol oder einem Gemisch aus einem oder mehreren dieser Lösungsmittel ausgewählt ist.

## Revendications

1. Procédé de polymérisation d'un composé hétéroaromatique sous formation de couplages C-C aryle-aryle, dans lequel ledit composé comporte au moins un groupement fonctionnel d'halogénure et au moins un groupement fonctionnel de bore, ou de copolymérisation d'au moins un premier et d'au moins un second composé hétéroaromatique sous formation de couplages C-C aryle-aryle, dans lequel ledit premier composé comporte au moins deux groupements fonctionnels d'halogénure et ledit second composé comporte au moins deux groupements fonctionnels de bore, dans lequel la polymérisation est réalisée en présence
a) d'un système de catalyseur/ligand comprenant un catalyseur au palladium et un composé d'organophosphine ou d'organophosphonium organique,
b) d'une base,
c) d'un solvant ou un mélange de solvants,
**caractérisé en ce que**
les groupements fonctionnels d'halogénure et de bore sont attachés à un cycle thiophène ou sélénophène éventuellement substitué et éventuellement condensé sur un autre cycle, et
le composé d'organophosphine ou d'organophosphonium organique est un sel de phosphine ou de phosphonium trisubstitué(e) ayant des substituants sélectionnés parmi des groupements alkyle et aryle éventuellement substitués, et
le composé d'organophosphine organique est formé *in situ* à partir du sel de phosphonium correspondant lors du procédé par addition de la base.

2. Procédé selon la revendication 1, **caractérisé en ce que** le groupement d'halogénure est sélectionné parmi un halogène ou -OSO₂R^{x} où R^{x} est alkyle ou aryle éventuellement fluoré ayant 1 à 12 atomes de C.

3. Procédé selon la revendication 2, **caractérisé en ce que** le groupement d'halogénure est sélectionné parmi Br, I, mésylate, triflate ou tosylate.

4. Procédé selon au moins l'une des revendications précédentes, **caractérisé en ce que** le groupement de bore est sélectionné parmi un acide boronique, un ester d'acide boronique (boronate) ou un groupement borane.

5. Procédé selon la revendication 4, **caractérisé en ce que** le groupement de bore répond à la formule -B(OR')(OR) ou BR'R', où R' et R'sont, indépendamment l'un de l'autre, H ou alkyle ayant 1 à 12 atomes de C, ou R' et R'forment ensemble un groupement alkylène ou arylène ayant de 2 à 20 atomes de C.

6. Procédé selon la revendication 5, **caractérisé en ce que** le groupement de bore est sélectionné parmi les formules suivantes :

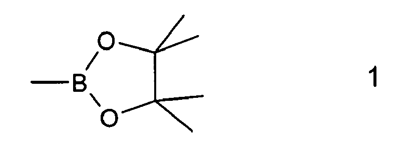

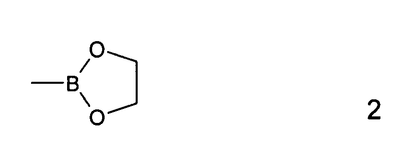

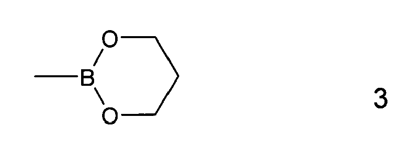

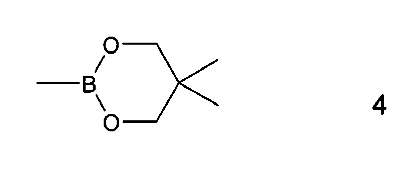

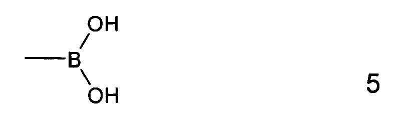

7. Procédé selon au moins l'une des revendications précédentes, **caractérisé en ce que** les composés hétéroaromatiques sont sélectionnés dans la formule I
X¹-(Ar¹)ₐ-(Ar²)_{b}-(Ar³)_{c}-X² I
dans laquelle
Ar¹ et Ar³ sont, dans le cas d'une occurrence multiple, indé- pendamment l'un de l'autre, des groupements arylène ou hétéroarylène identiques ou différents, qui sont éventuellement substitués par un ou plu- sieurs groupements R, comprennent éventuelle- ment des cycles condensés, et comprennent un cycle thiophène ou un cycle sélénophène lié à X¹ et/ou à X², respectivement,
Ar² est, dans le cas d'une occurrence multiple, indépendamment l'un de l'autre, un groupement arylène ou hétéroarylène qui est éventuellement substitué par un ou plusieurs groupements R et comprend éventuellement des cycles condensés,
a et c valent, indépendamment l'un de l'autre, 1, 2 ou 3, et dans le cas où b vaut 0, l'un parmi a et c peut aussi valoir 0,
b vaut 0, 1, 2, 3 ou 4,
X¹ et X² sont, indépendamment l'un de l'autre, un groupe- ment fonctionnel d'halogénure ou un groupement fonctionnel de bore,
R dans le cas d'une occurrence multiple, indépen- damment l'un de l'autre, revêt l'une des significa- tions pour X¹ ou représente aryle, hétéroaryle, aryloxy ou hétéroaryloxy, qui est éventuellement substitué par un ou plusieurs groupements L, ou alkyle à chaîne linéaire, ramifiée ou cyclique ayant 1 à 20 atomes de C, qui est éventuellement mono- ou polysubstitué par F, CI, Br ou I, et où un ou plusieurs groupements CH₂ non adjacents sont éventuellement remplacés, à chaque fois indépen- damment les uns des autres, par -O-, -S-, -NR⁰-, -SiR⁰R⁰⁰-, -CY¹=CY²- ou -C≡C- de sorte que les atomes de O et/ou S ne soient pas directement liés les uns aux autres, ou est sélectionné parmi F, CI, CN, NO₂, NR⁰R⁰⁰, -SiR⁰R⁰⁰R⁰⁰⁰, -C≡C-SiR⁰R⁰⁰R⁰⁰⁰ ou sulfonyle, ou est H,
L est F, Cl, Br, I, CN, NO₂, NR⁰R⁰⁰, -SiR⁰R⁰⁰R⁰⁰⁰, -C≡C-SiR⁰R⁰⁰R⁰⁰⁰, sulfonyle, ou alkyle à chaîne linéaire, ramifiée ou cyclique ayant 1 à 20 atomes de C, qui est non substitué ou mono- ou polysubs- titué par F, CI, Br, I, -CN ou -OH, et où un ou plu- sieurs groupements CH₂ non adjacents sont éven- tuellement remplacés, à chaque fois indépendam- ment les uns des autres, par -O-, -S-, -NR⁰-, -SiR⁰R⁰⁰-, -CY¹=CY²- ou -C≡C- de manière telle que les atomes de O et/ou S ne soient pas direc- tement liés les uns aux autres,
Y¹ et Y² sont, indépendamment l'un de l'autre, H, F ou CI,
R⁰, R⁰⁰ et R⁰⁰⁰ sont, indépendamment les uns des autres, H, alkyle ayant 1 à 12 atomes de C, ou aryle.

8. Procédé selon la revendication 7, **caractérisé en ce que** Ar¹ et Ar³ sont sélectionnés parmi thiophène-2,5-diyle, sélénophène-2,5-diyle ou thiéno[2,3-b]thiophène-2,5-diyle qui sont éventuellement substitués en position 3 et/ou 4 par R, thiéno[3,2-b]thiophène-2,5-diyle qui est éventuellement substitué en position 3 et/ou 6 par R, ou benzo[1,2-b:4,5-b']dithiophène-2,6-diyle qui est éventuellement substitué en position 3, 4, 7 ou 8 par R.

9. Procédé selon au moins l'une des revendications précédentes, **caractérisé en ce que** les composés hétéroaromatiques sont sélectionnés parmi les formules suivantes : 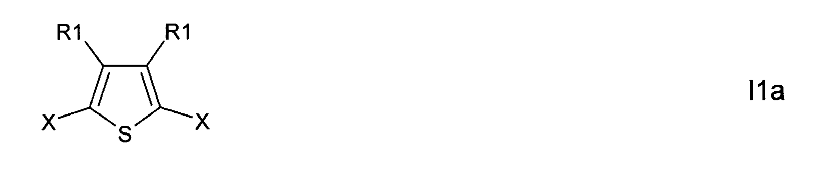 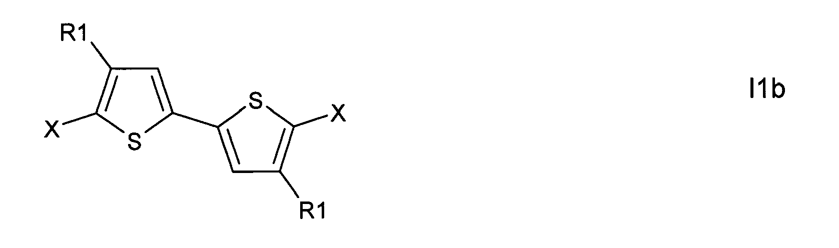 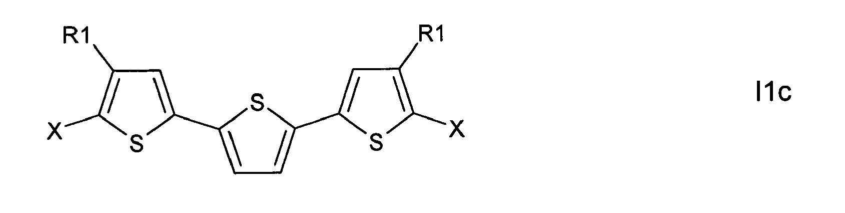 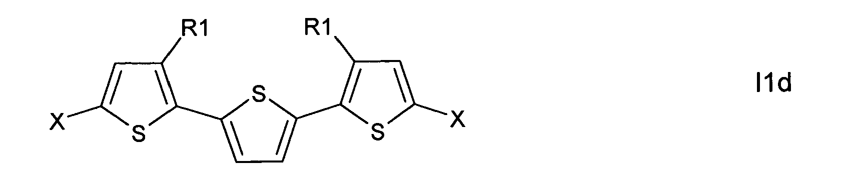 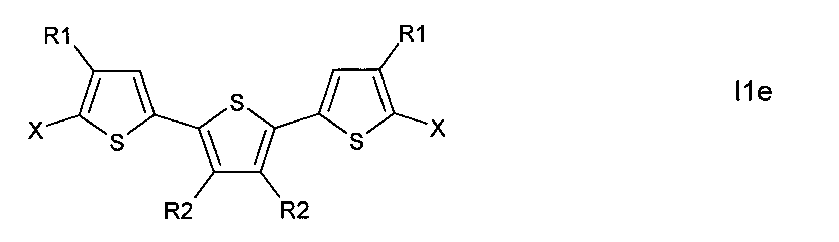 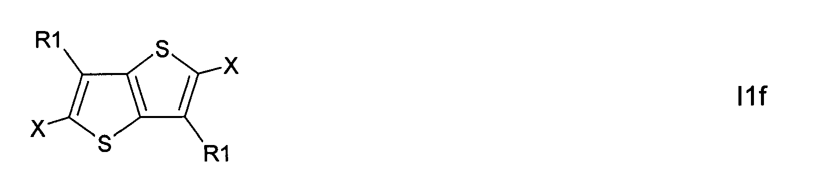 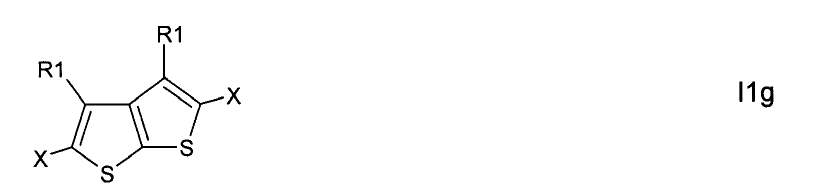 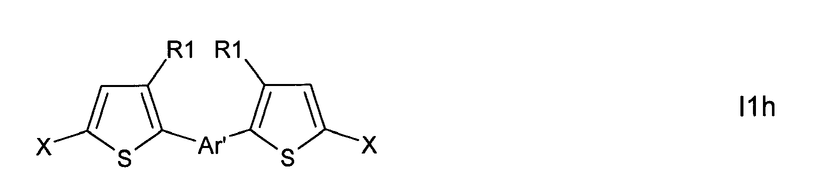 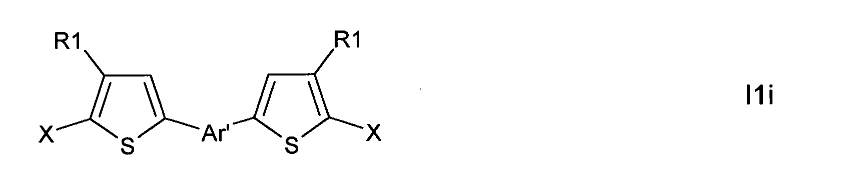 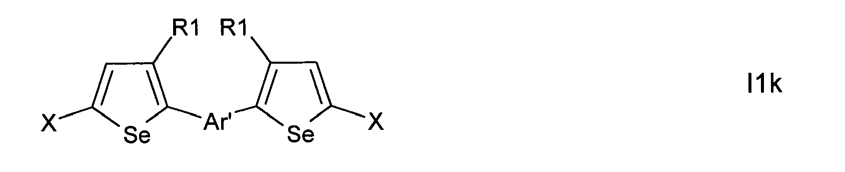 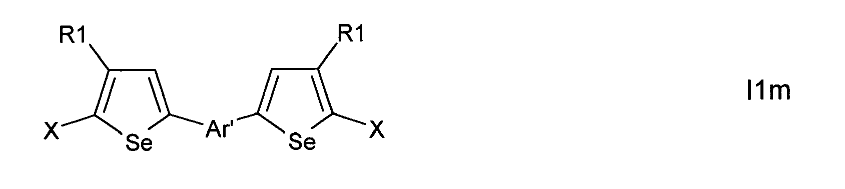 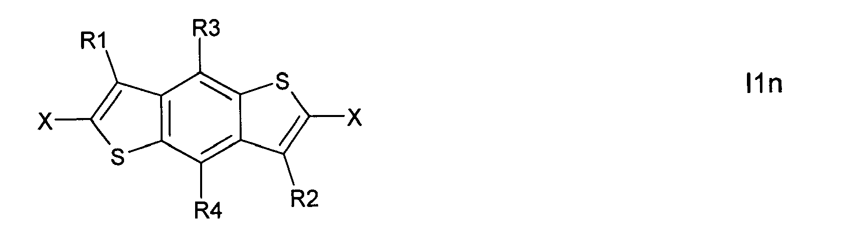 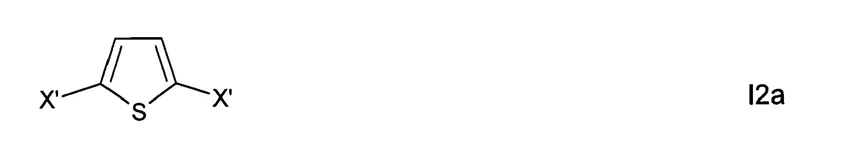 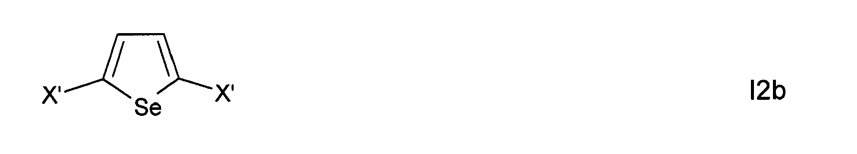 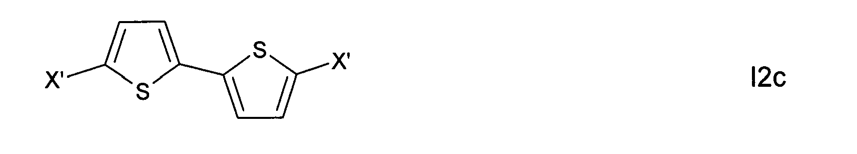 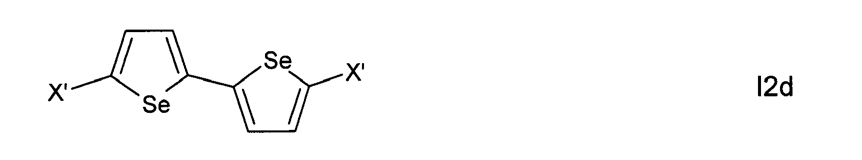 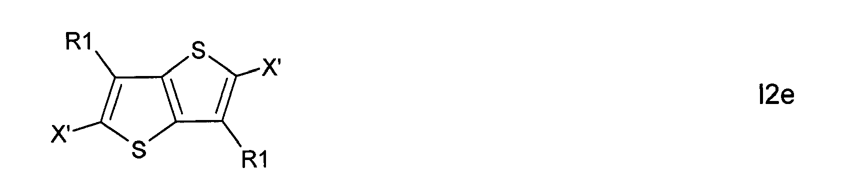 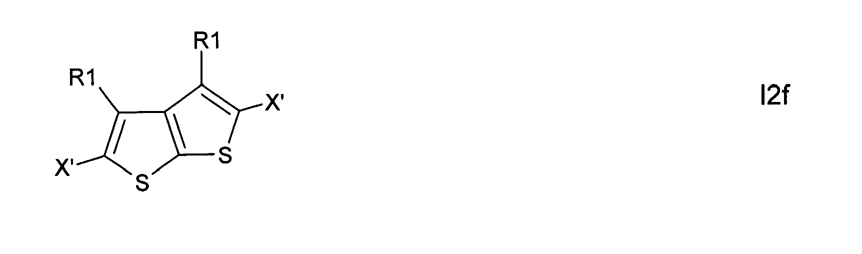 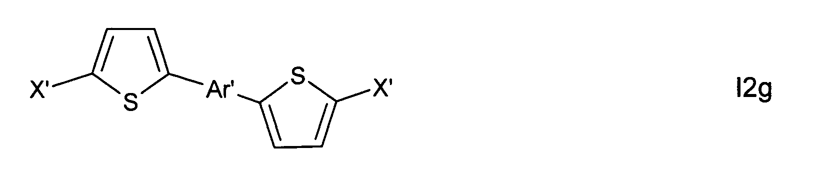 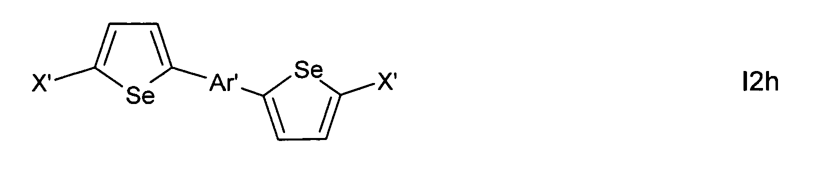 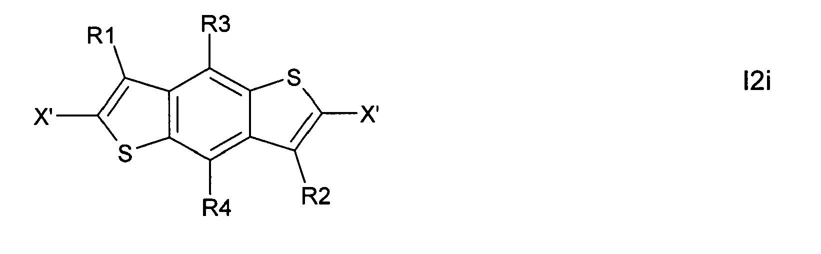 dans lesquelles
Ar' revêt l'une des significations de Ar² données selon les revendications précédentes,
X est un groupement d'halogénure tel que défini selon les revendications précédentes,
X' est un groupement de bore tel que défini selon les revendications précédentes, et
R¹⁻⁴ revêtent, indépendamment les uns des autres, l'une des significations de R selon la formule I.

10. Procédé selon au moins l'une des revendications précédentes, **caractérisé en ce que** le catalyseur au palladium est sélectionné parmi les halogénures de Pd(II), les carboxylates de Pd(II), les β-dicétonates de Pd(II), Pd₂(dba)₃, Pd(dba)₂, Pd(PR'₃)₂, Pd(OAc)₂, PdCl₂(PR'₃)₂, PdCl₂(PhCN)₂, PdCl₂(CH₃CN) ou PdCl₂(cod), où R' est alkyle ou aryle.

11. Procédé selon l'une ou plusieurs des revendications précédentes, **caractérisé en ce que** le catalyseur au palladium est un catalyseur au palladium(II) dépourvu de phosphine.

12. Procédé selon au moins l'une des revendications précédentes, **caractérisé en ce que** la phosphine trisubstituée répond à la formule R^{a}ₓR^{b}_{y}R^{c}_{z}P, dans laquelle
P désigne le phosphore,
R^{a}, R^{b} et R^{c} sont des groupements alkyle identiques ou différents à chaîne linéaire, ramifiée ou cyclique ayant 1 à 12 atomes de C éventuellement fluorés, ou des groupements aryle ayant 4 à 20 atomes de C éventuellement substitués,
x, y et z valent 0, 1, 2 ou 3, avec x+y+z = 3.

13. Procédé selon la revendication 12, **caractérisé en ce que** la phosphine trisubstituée répond à la formule R^{a}₃P dans laquelle tous les groupements R^{a} sont identiques, ou répond à l'une des formules R^{a}₂R^{b}P ou R^{a}R^{b}₂P dans lesquelles R^{a} et R^{b} sont différents.

14. Procédé selon la revendication 12 ou 13, **caractérisé en ce que** R^{a} et R^{b} sont alkyle tel que défini selon la revendication 12, ou R^{a} est un groupement alkyle et R^{b} est un groupement aryle tels que définis selon la revendication 12.

15. Procédé selon au moins l'une des revendications 12 à 14, **caractérisé en ce que** la phosphine trisubstituée est sélectionnée parmi la triéthylphosphine, la triisopropylphosphine, la tricyclohexylphosphine, la tris(tertio-butyl)phosphine (t-Bu), le bis(di-tertio-butylphosphino)méthane et le 2-dicyclohexylphosphino-2',6'-diméthoxybiphényle.

16. Procédé selon au moins l'une des revendications 12 à 15, **caractérisé en ce que** le sel de phosphonium trisubstitué est sélectionné dans la formule [R^{a}ₓR^{b}_{y}R^{c}_{z}PH]⁺Z⁻, dans laquelle R^{a-c} et x, y et z sont tels que définis selon la revendication 12 et Z⁻est un anion convenable.

17. Procédé selon la revendication 16, **caractérisé en ce que** Z⁻ est BF₄⁻, PF₆⁻ ou SbF₆⁻.

18. Procédé selon la revendication 16 ou 17, **caractérisé en ce que** le sel de phosphonium trisubstitué est [t-Bu₃PH]BF₄.

19. Procédé selon au moins l'une des revendications précédentes, **caractérisé en ce que** la base est sélectionnée parmi les hydroxydes, carboxylates, carbonates, fluorures et phosphates de métaux alcalins ou alcalino-terreux.

20. Procédé selon la revendication 19, **caractérisé en ce que** la base est K₂CO₃ ou Na₂CO₃ aqueux.

21. Procédé selon au moins l'une des revendications précédentes, **caractérisé en ce qu'**au moins 1,5 équivalent de ladite base par groupement fonctionnel de bore est présent dans le mélange réactionnel.

22. Procédé selon au moins l'une des revendications précédentes, **caractérisé en ce que** le solvant est sélectionné parmi le toluène, le xylène, l'anisole, le THF, le 2-méthyltétrahydrofurane, le dioxane, le chlorobenzène, le fluorobenzène ou un mélange d'un ou plusieurs parmi ces solvants.
